(19) Europäisches Patentamt
European Patent Office
Office européen des brevets

(11) EP 4 206 301 A1

(12) # EUROPEAN PATENT APPLICATION
published in accordance with Art. 153(4) EPC

(43) Date of publication:
**05.07.2023 Bulletin 2023/27**

(21) Application number: **21861694.4**

(22) Date of filing: **26.08.2021**

(51) International Patent Classification (IPC):
***C09K 11/06*** *(2006.01)* ***H01L 51/50*** *(2006.01)*

(52) Cooperative Patent Classification (CPC):
**C09K 11/06; H10K 50/00**

(86) International application number:
**PCT/JP2021/031430**

(87) International publication number:
**WO 2022/045272 (03.03.2022 Gazette 2022/09)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **28.08.2020 JP 2020144607**

(71) Applicant: **NIPPON STEEL Chemical & Material Co., Ltd.**
**Tokyo 103-0027 (JP)**

(72) Inventors:
- **KITERA, Sayuri**
**Tokyo 103-0027 (JP)**
- **TADA, Masashi**
**Tokyo 103-0027 (JP)**
- **INOUE, Munetomo**
**Tokyo 103-0027 (JP)**
- **TERADA, Ayaka**
**Tokyo 103-0027 (JP)**
- **UKIGAI, Satoshi**
**Tokyo 103-0027 (JP)**

(74) Representative: **Vossius & Partner**
**Patentanwälte Rechtsanwälte mbB**
**Siebertstraße 3**
**81675 München (DE)**

(54) **ORGANIC ELECTROLUMINESCENT ELEMENT**

(57) Provided is a blue light emitting organic EL device having high emission efficiency and a long lifetime.

This organic EL device includes one or more light emitting layers between an anode and a cathode opposite to each other, wherein at least one of the light emitting layers has a difference between excited singlet energy (S1) and excited triplet energy (T1) of 0.20 eV or less and includes a light emitting dopant represented by the following formula (5), a first host selected from biscarbazole compounds, and a second host selected from N-containing 6-membered ring compounds, wherein $X^3$ is N-$Ar^4$, O, or S and at least one $X^3$ is N-$Ar^4$.

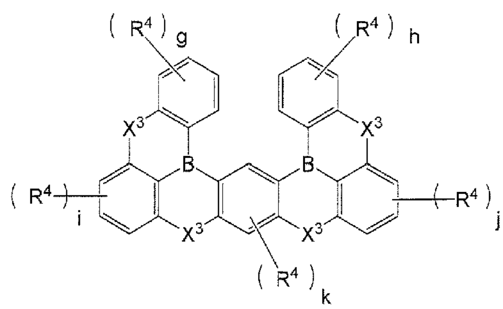

(5)

EP 4 206 301 A1

[Fig. 1]

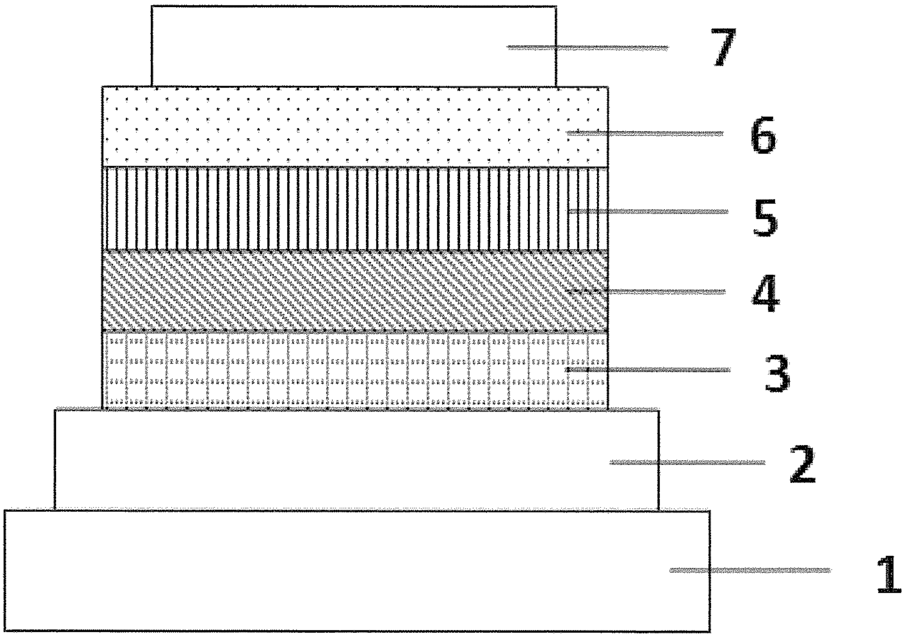

## Description

Technical Field

The present invention relates to an organic electroluminescent device or element (also referred to as an organic EL device or element).

When a voltage is applied to an organic EL device, holes and electrons are injected from the anode and the cathode, respectively, into the light emitting layer. Then, the injected holes and electrons are recombined in the light emitting layer to thereby generate excitons.

At this time, according to the electron spin statistics theory, singlet excitons and triplet excitons are generated at a ratio of 1:3. In the fluorescent organic EL device that uses emission caused by singlet excitons, the limit of the internal quantum efficiency is said to be 25%. On the other hand, it has been known that, in the phosphorescent organic EL device that uses emission caused by triplet excitons, the internal quantum efficiency can be enhanced up to 100% when intersystem crossing efficiently occurs from singlet excitons.

However, the blue phosphorescent organic EL device has a technical problem of extending the lifetime.

Further, a highly efficient organic EL device utilizing delayed fluorescence has been developed, in recent years. For example, Patent Literature 1 discloses an organic EL device utilizing the Triplet-Triplet Fusion (TTF) mechanism, which is one of the mechanisms of delayed fluorescence. The TTF mechanism utilizes a phenomenon in which a singlet exciton is generated by the collision of two triplet excitons, and it is believed that the internal quantum efficiency can be enhanced up to 40%, in theory. However, its efficiency is low as compared with the efficiency of the phosphorescent organic EL device, and thus further improvement in efficiency is desired.

On the other hand, Patent Literature 2 discloses an organic EL device utilizing the Thermally Activated Delayed Fluorescence (TADF) mechanism. The TADF mechanism utilizes a phenomenon in which reverse intersystem crossing occurs from the triplet exciton to the singlet exciton in a material having a small energy difference between the singlet level and the triplet level, and it is believed that the internal quantum efficiency can be enhanced up to 100%, in theory. However, further improvement in lifetime characteristics is desired as in the phosphorescent device.

Citation List

Patent Literature

Patent Literature 1: WO2010/134350
Patent Literature 2: WO2011/070963
Patent Literature 3: WO2015/102118
Patent Literature 4: WO2017/115833
Patent Literature 5: WO2018/212169
Patent Literature 6: WO2018/181188
Patent Literature 7: WO2020/040298
Patent Literature 8: JP2020/120096

Patent Literature 4 discloses an organic EL device including two types of host materials exemplified by the following compounds and a TADF material as a light emitting dopant in a light emitting layer.

[C1]

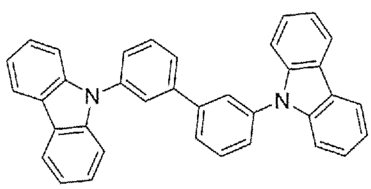

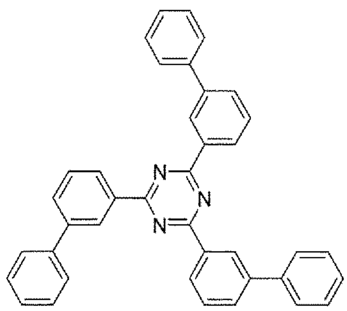

Patent Literature 3 and Patent Literature 5 disclose an organic EL device in which a TADF material including a polycyclic aromatic compound exemplified by the following compound is used as a light emitting dopant.

[C2]

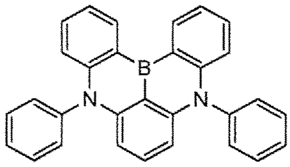

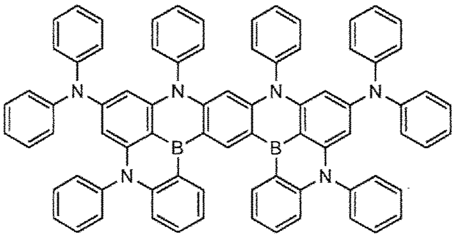

Patent Literature 6 discloses an organic EL device in which a boron-based compound, a TADF material, and a carbazole compound (a3) are mixed and used for a light emitting layer.

Patent Literature 7 discloses an organic EL device in which a boron-based compound, a TADF material, and a carbazole compound are mixed and used for a light emitting layer.

Patent Literature 8 discloses an organic EL device in which a boron-based compound (a7), a nitrogen-containing six-membered ring compound (a8), and a carbazole compound (a9) are mixed and used for a light emitting layer.

[C3]

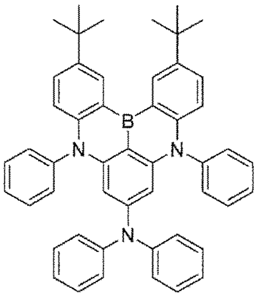

a7

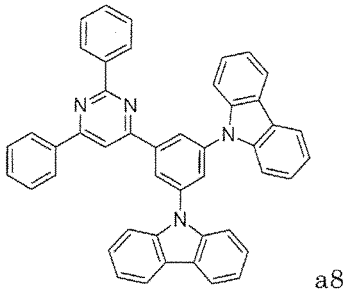

a8

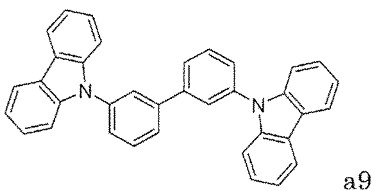

a9

No literature, however, discloses an organic EL device exhibiting sufficient lifetime characteristics.

Summary of Invention

In order to apply an organic EL device to a display device such as a flat panel display and a light source, it is necessary to improve the emission efficiency of the device and sufficiently ensure the stability of the device at the time of driving, at the same time. An object of the present invention is to provide a practically useful organic EL device having high efficiency and a long lifetime.

The present invention is an organic EL device comprising one or more light emitting layers between an anode and a cathode opposite to each other, wherein at least one of the emitting layers comprises a first host selected from compounds represented by the following general formula (1), a second host selected from compounds represented by the following general formula (2), and, as a light emitting dopant, a polycyclic aromatic compound represented by the following general formula (4):

[C4]

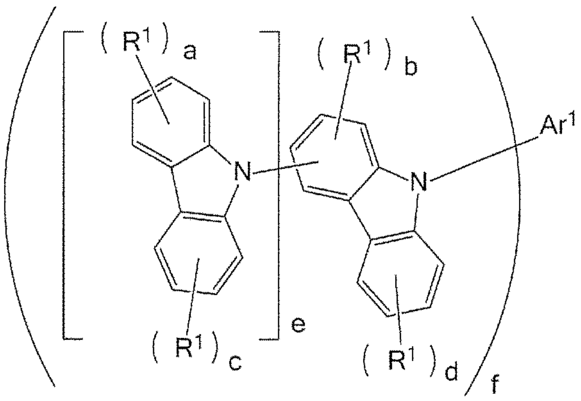

(1)

wherein $Ar^1$ represents a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group formed by linking 2 to 8 aromatic group thereof.

$R^1$ is each independently deuterium, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms.

a, c and d independently represent an integer of 0 to 4, b independently represents an integer of 0 to 3, e independently represents an integer of 1 to 4, and f represents an integer of 1 or 2.

[C5]

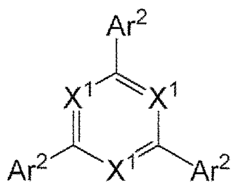

(2)

wherein $X^1$ each independently represents N or C-$R^2$, and at least one $X^1$ represents N.

$Ar^2$ each independently represents hydrogen, a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group formed by linking 2 to 8 aromatic rings thereof. Provided that cases where all of $Ar^2$ groups are hydrogen are excluded.

$R^2$ independently represents hydrogen, deuterium, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms.

[C6]

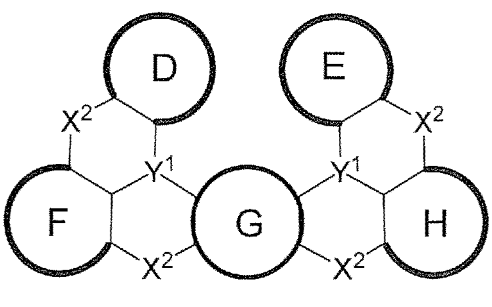

(4)

wherein the D ring, the E ring, the F ring, the G ring, and the H ring are each independently a substituted or unsubstituted aromatic hydrocarbon ring having 6 to 24 carbon atoms, or a substituted or unsubstituted aromatic heterocyclic ring having 3 to 17 carbon atoms,

$Y^1$ is B, P, P=O, P=S, Al, Ga, As, Si-$R^3$ or Ge-$R^3$,
$R^3$ is each independently an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms,
$X^2$ is each independently O, N-$Ar^3$, S or Se,
$Ar^3$ is each independently a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group formed by linking 2 to 8 of these groups, N-$Ar^3$ is optionally bonded to any of the D ring, the E ring, the F ring, the G ring, or the H ring to form a heterocyclic ring containing N, and at least one hydrogen atom in the D ring, the E ring, the F ring, the G ring, and the H ring, is optionally replaced with a deuterium atom.

In a preferred example of the general formula (1), $Ar^1$ in formula (1) is a substituted or unsubstituted aromatic hydrocarbon group having 6 to 18 carbon atoms or a substituted or unsubstituted condensed aromatic heterocyclic group having 6 to 17 carbon atoms.

A preferred example of the polycyclic aromatic compound represented by the general formula (4) is a boron-containing polycyclic aromatic compound represented by the following formula (5):

[C7]

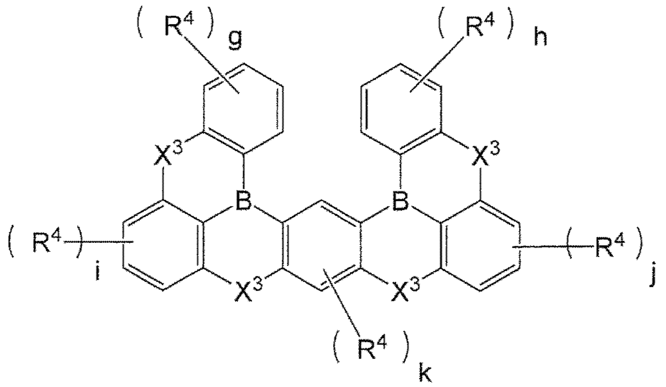

(5)

wherein $X^3$ each independently represents N-$Ar^4$, O or S, and at least one $X^3$ represents N-$Ar^4$. $Ar^4$ each independently represents a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic ring formed by linking 2 to 8 aromatic rings thereof. N-$Ar^4$ may be bonded to the benzene ring to which N-$Ar^4$ is bonded to form a heterocyclic ring containing N.

$R^4$ each independently represents a cyano group, deuterium, a diarylamino group having 12 to 44 carbon atoms, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms, and
g and h each independently represent an integer of 0 to 4, i and j each independently represent an integer of 0 to 3, and k represents an integer of 0 to 2.

A preferred example of the aforementioned general formula (2) is formula (6), formula (7) or formula (8) below.

[C8]

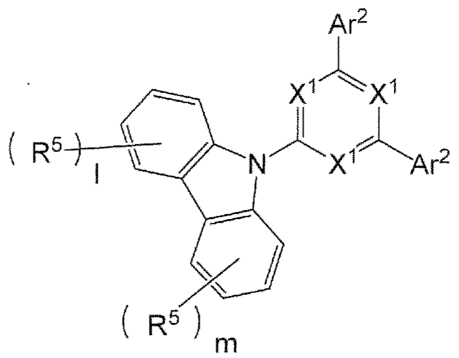

(6)

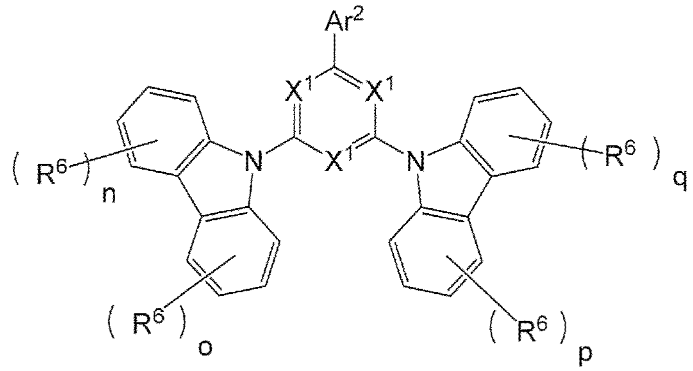

(7)

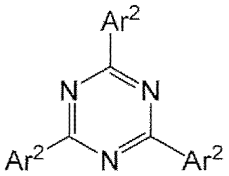

(8)

wherein $Ar^2$ and $X^1$ are as defined in the general formula (2),

$R^5$ and $R^6$ each independently represent deuterium, an aliphatic hydrocarbon group having 1 to 10 carbon atoms, a triarylsilyl group having 18 to 36 carbon atoms, a substituted or unsubstituted aromatic hydrocarbon group having 6 to 18 carbon atoms, or a substituted or unsubstituted aromatic heterocyclic group having 3 to 17 carbon atoms, and 1, m, n, o, p, and q each independently represent an integer of 0 to 4.

The aforementioned light emitting dopant preferably has a difference (Δ EST) between excited singlet energy (S1) and excited triplet energy (T1) of 0.20 eV or less and more preferably 0.10 eV or less.

The organic EL device of the present invention is characterized by high emission efficiency as well as a long lifetime.

The reason for the high emission efficiency of the organic EL device of the present invention is probably as follows: excitons generated on a host are rapidly transferred to the light emitting dopant, resulting in little energy loss, and excitons generated on the light emitting dopant are hardly transferred to the host, resulting in little energy loss. Moreover, the reason for the high emission efficiency is also presumed as follows: the carbazole compound is characterized in that holes are easily injected thereinto and the nitrogen-containing six-membered ring compound is characterized in that electrons are easily injected thereinto, whereby the balance between holes and electrons in the light emission layer can be maintained. The reason for the long lifetime of the organic EL device of the present invention is presumed as follows: when a voltage is applied to the organic EL device, holes are preferentially injected into the first host, i.e., the biscarbazole compound, and electrons are preferentially injected into the second host, i.e., the nitrogen-containing six-membered ring compound, whereby an electrochemical load on the light emitting dopant is reduced.

The aforementioned polycyclic aromatic compound can emit blue light with high efficiency by utilizing the TADF mechanism; however it has less resistance to holes and electrons, thereby resulting in a tendency to shorten a device lifetime. In the present invention, holes are likely to be injected into the first host used, and electrons are likely to be injected into the second host as well; accordingly, it is considered that the electrochemical load on the light emitting

dopant can be reduced and that the resulting device can thus exhibit long-life characteristics. Furthermore, it is presumed that an organic El device with a long lifetime can be provided since the aforementioned first host and second host are more resistant to holes and electrons than known host materials.

Brief Description of Drawing

[Figure 1] Figure 1 shows a cross-sectional view of one example of the organic EL device.

Description of Embodiments

The organic EL device of the present invention includes one or more light emitting layers between an anode and a cathode opposite to each other, wherein at least one of the emitting layers includes the first host selected from compounds represented by the aforementioned general formula (1), the second host selected from compounds represented by the aforementioned general formula (2), and, as a light emitting dopant, a polycyclic aromatic compound represented by the aforementioned general formula (4).

The compound represented by the aforementioned general formula (1) used as the first host in the present invention will be described below.

In the general formula (1), $Ar^1$ represents a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group formed by linking 2 to 8 aromatic rings thereof. $Ar^1$ preferably represents a substituted or unsubstituted aromatic hydrocarbon group having 6 to 12 carbon atoms, a substituted or unsubstituted condensed aromatic heterocyclic group having 6 to 17 carbon atoms, or a substituted or unsubstituted linked aromatic group formed by linking 2 to 4 aromatic rings thereof. $Ar^1$ more preferably represents a substituted or unsubstituted aromatic hydrocarbon group having 6 to 10 carbon atoms or a substituted or unsubstituted linked aromatic group formed by linking 2 to 3 aromatic rings thereof.

When $Ar^1$ is the unsubstituted aromatic hydrocarbon group, the aromatic heterocyclic group or the linked aromatic group, specific examples thereof include a group produced by removing the number f of hydrogen atoms from benzene, naphthalene, acenaphthene, acenaphthylene, azulene, anthracene, chrysene, pyrene, phenanthrene, triphenylene, fluorene, benzo[a]anthracene, thiophene, isothiazole, thiazole, pyridazine, pyrrole, pyrazole, imidazole, pyrazine, furan, isoxazole, quinoline, isoquinoline, quinoxaline, quinazoline, phthalazine, indole, pyridine, pyrimidine, triazine, benzofuran, benzothiophene, benzoxazole, benzothiazole, indazole, benzimidazole, benzotriazole, benzoisothiazole, benzothiadiazole, purine, pyranone, coumarin, isocoumarin, chromone, dibenzofuran, dibenzothiophene, dibenzoselenophene, carbazole, or a compound formed by linking 2 to 8 thereof. They are each preferably a group produced by removing the number f of hydrogen atoms from benzene, naphthalene, acenaphthene, acenaphthylene, azulene, dibenzofuran, dibenzothiophene, carbazole, or a compound formed by linking 2 to 4 of these compounds. More preferably, $Ar^1$ is a group produced by removing the number f of hydrogen atoms from benzene, naphthalene, or a compound formed by linking 2 to 3 benzene rings.

The linked aromatic group as used herein refers to a group in which aromatic rings of two or more members selected from an aromatic hydrocarbon group and an aromatic heterocyclic group are linked by a single bond. The aromatic rings may be linked in a linear or branched manner, and may be the same or different.

$R^1$ represents independently deuterium, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms. Preferably, $R^1$ is an aliphatic hydrocarbon group having 1 to 8 carbon atoms, a substituted or unsubstituted aromatic hydrocarbon group having 6 to 12 carbon atoms, or a substituted or unsubstituted aromatic heterocyclic group having 3 to 15 carbon atoms. More preferably, $R^1$ is a substituted or unsubstituted aromatic hydrocarbon group having 6 to 10 carbon atoms, or a substituted or unsubstituted aromatic heterocyclic group having 3 to 12 carbon atoms.

It is preferable that $Ar^1$ or $R^1$ should not be a group produced from pyridine, pyrimidine, or triazine.

a, c and d independently represent an integer of 0 to 4, b independently represents an integer of 0 to 3, e independently represents an integer of 1 to 4, and f represents an integer of 1 or 2. Preferably, a, b, c, and d are independently an integer of 0 to 1, and e is an integer of 1 to 2. These are the number of substitutions.

When f is 2, the general formula (1) may be symmetric or asymmetric.

When $R^1$ is an aliphatic hydrocarbon group having 1 to 10 carbon atoms, specific examples of $R^1$ include methyl, ethyl, propyl, butyl, pentyl, hexyl, heptyl, octyl, or nonyl. Preferred examples thereof include methyl, ethyl, propyl, butyl, pentyl, hexyl, heptyl, or octyl.

When $R^1$ is an unsubstituted aromatic hydrocarbon group having 6 to 18 carbon atoms or an unsubstituted aromatic heterocyclic group having 3 to 17 carbon atoms, specific examples thereof are the same as described for the aforementioned $Ar^1$.

Preferably, $R^1$ is a group produced by removing one hydrogen atom from benzene, naphthalene, acenaphthene, acenaphthylene, azulene, dibenzofuran, dibenzothiophene, or carbazole. More preferably, $R^1$ is a group produced by removing one hydrogen atom from benzene, naphthalene, or carbazole.

In the general formula (1), when a plurality of carbazoles is linked, they preferably have the bonding structure of the 3,9-position linkage as shown in the following formula (1a), or the 4,9-position linkage as shown in (1b); however, they are not limited to these bonding structures.

[C9]

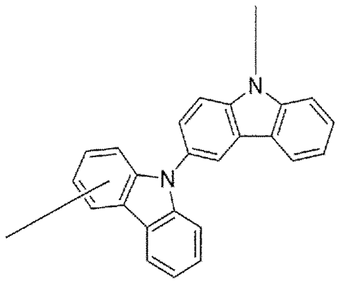

(1a)

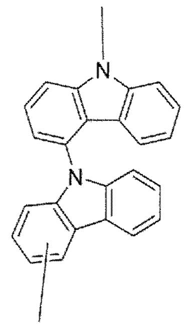

(1b)

In the general formula (1), the general formula (2), formula (6), formula (7) and formula (8), when $Ar^1$ to $Ar^3$ and $R^1$ to $R^5$ are aromatic hydrocarbon groups, aromatic heterocyclic groups or linked aromatic groups, they may have substituents, and each of the substituents is preferably deuterium, a cyano group, a triaryl silyl group having 18 to 36 carbon atoms, an aliphatic hydrocarbon group having 1 to 10 carbon atoms, or a diarylamino group having 12 to 44 carbon atoms. Here, when the substituent is the aliphatic hydrocarbon group having 1 to 10 carbon atoms, it may be linear, branched, or cyclic. The number of substituents is 0 to 5, and preferably 0 to 2. When each of the aromatic hydrocarbon groups and aromatic heterocyclic groups has a substituent, the number of carbon atoms of the substituent is not included in the calculation of the number of carbon atoms. However, it is preferred that the total number of carbon atoms including the number of carbon atoms of the substituent satisfy the above range.

Specific examples of the above substituent include cyano, methyl, ethyl, propyl, i-propyl, butyl, t-butyl, pentyl, cyclopentyl, hexyl, cyclohexyl, heptyl, octyl, nonyl, decyl, diphenylamino, naphthylphenylamino, dinaphthylamino, dianthranylamino, diphenanthrenylamino, dipyrenylamino, and triphenyl silyl groups. Preferred examples thereof include cyano, methyl, ethyl, propyl, butyl, pentyl, hexyl, heptyl, octyl, diphenylamino, naphthylphenylamino, and dinaphthylamino groups.

Herein, the hydrogen may be understood to be deuterium. Namely, in the aforementioned general formulae (1) to (8), one or more H atoms or all H atoms of a carbazole skeleton and substituents such as $R^1$ and $Ar^1$ have may be a deuterium atom.

Specific examples of the compounds represented by the general formula (1) are shown below, but the compounds are not limited to these exemplified compounds.

[C10]

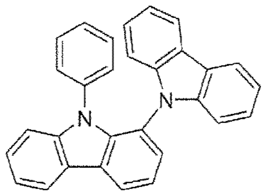
1-1

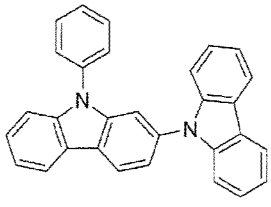
1-2

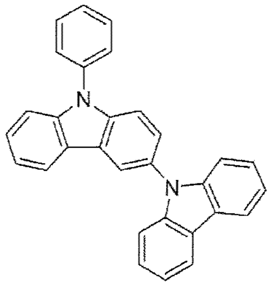
1-3

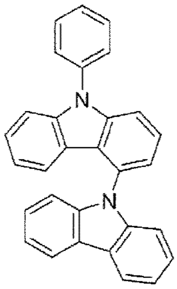
1-4

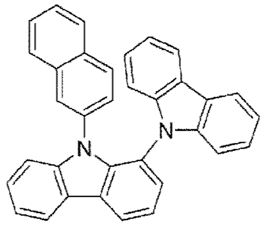
1-5

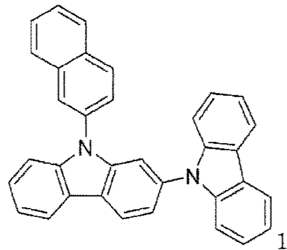
1-6

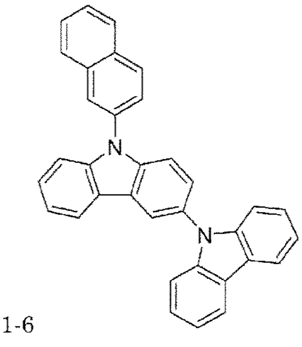
1-7

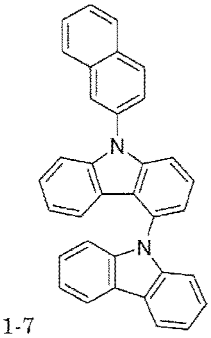
1-8

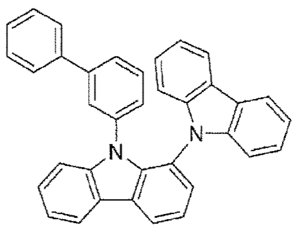
1-9

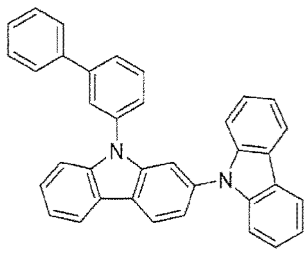
1-10

[C11]

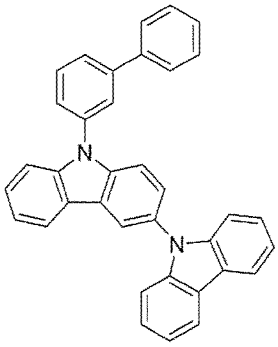
1-11

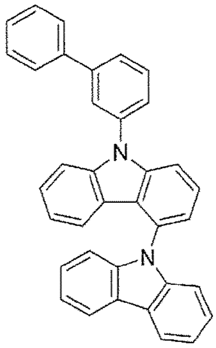
1-12

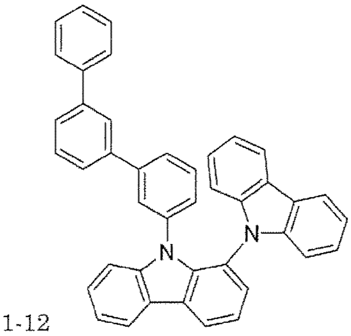
1-13

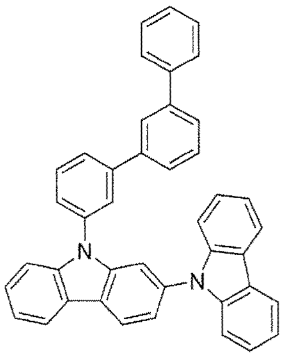
1-14

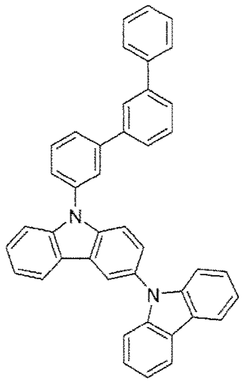
1-15

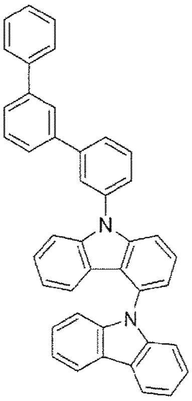
1-16

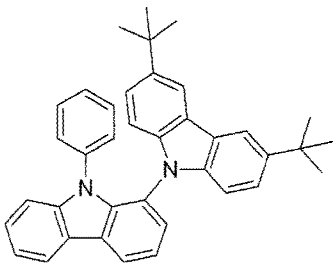
1-17

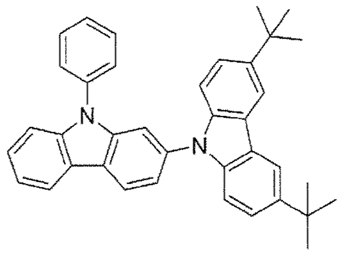
1-18

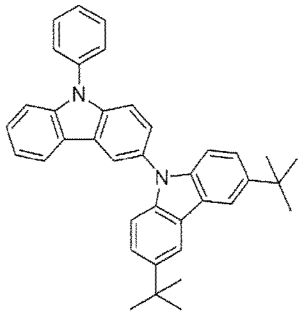
1-19

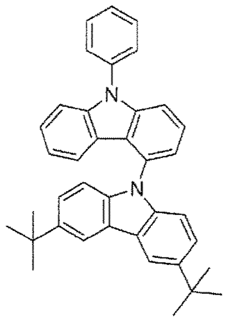
1-20

[C12]

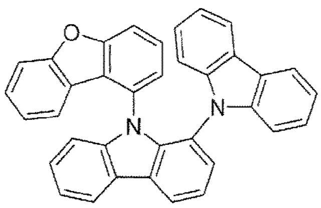
1-21

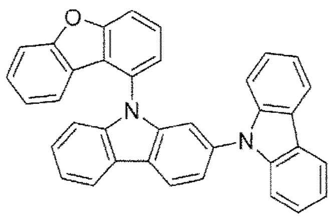
1-22

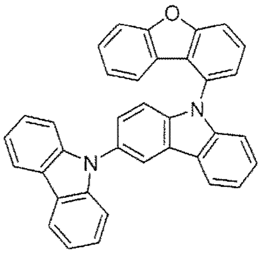
1-23

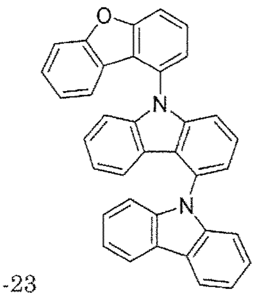
1-24

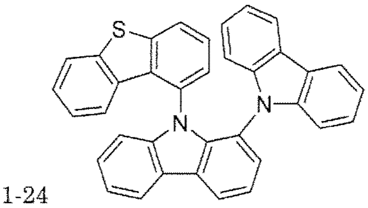
1-25

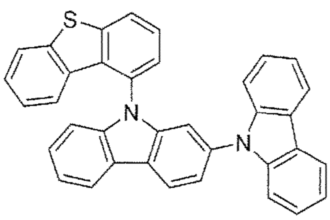
1-26

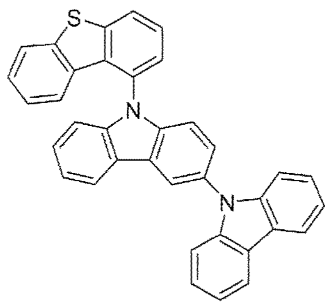
1-27

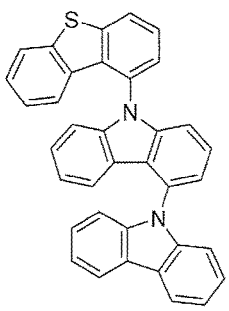
1-28

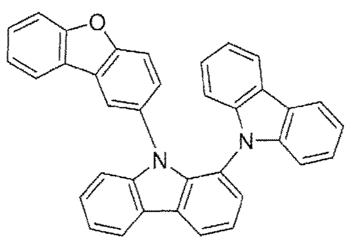
1-29

[C13]

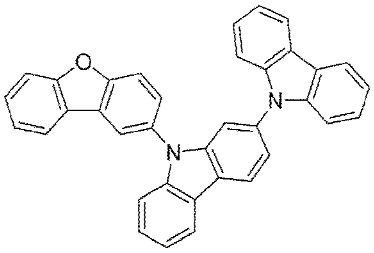
1-30

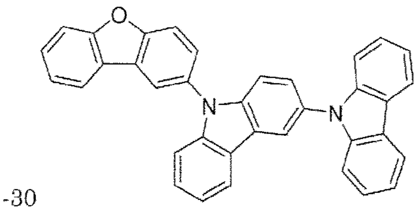
1-31

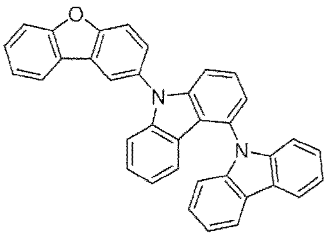
1-32

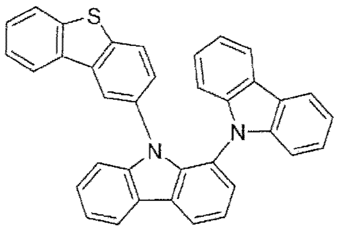
1-33

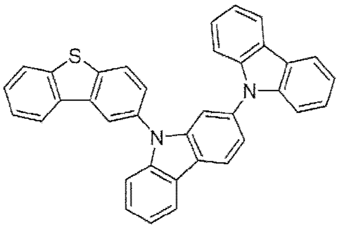
1-34

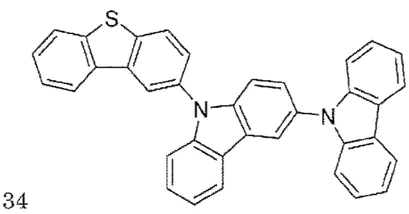
1-35

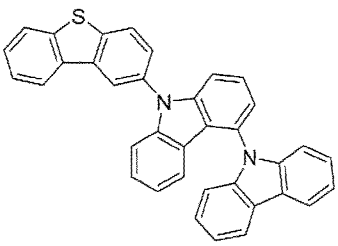
1-36

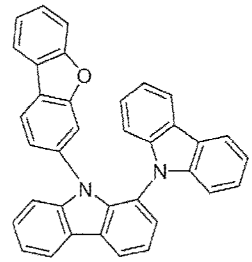
1-37

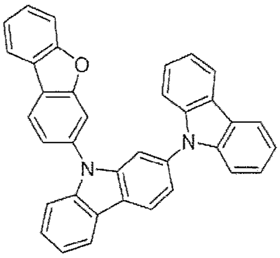
1-38

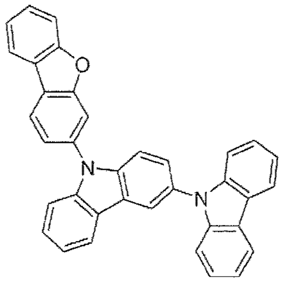
1-39

[C14]

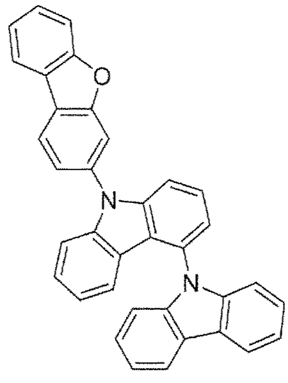
1-40

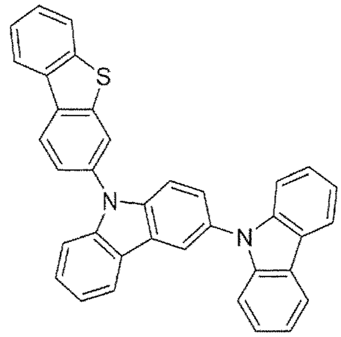
1-41

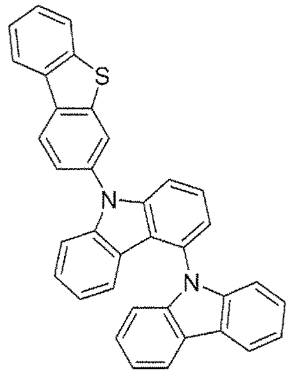
1-42

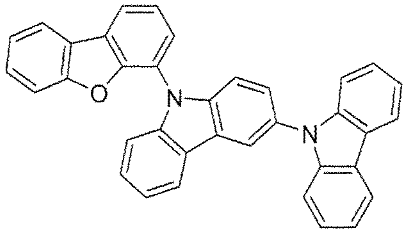
1-43

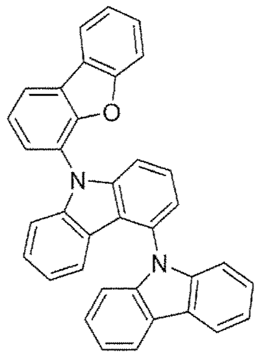
1-44

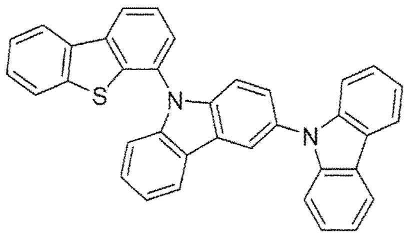
1-45

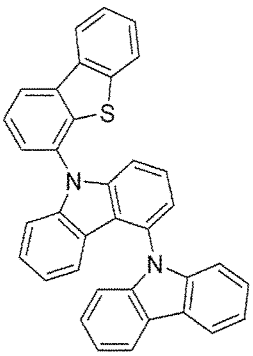
1-46

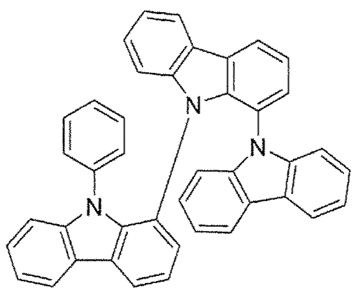
1-47

[C15]

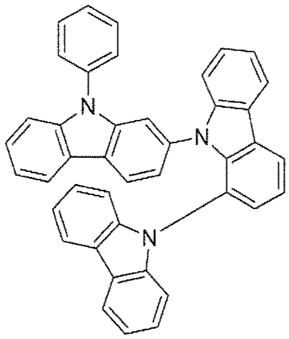
1-48

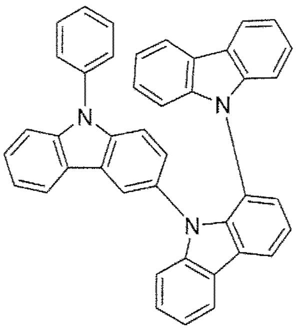
1-49

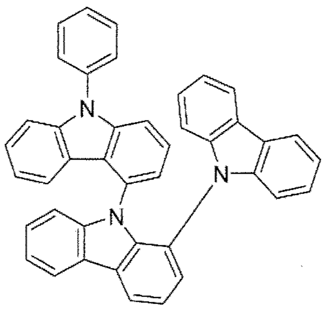
1-50

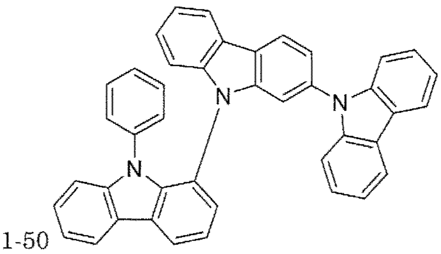
1-51

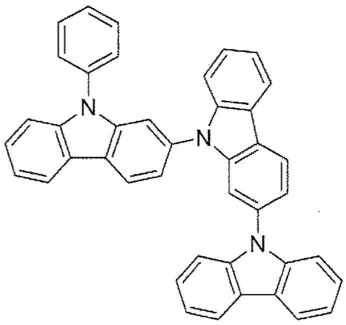
1-52

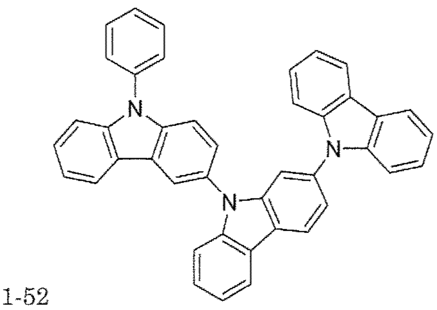
1-53

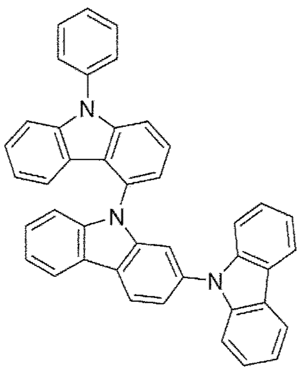
1-54

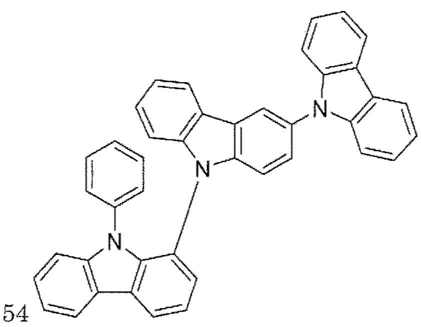
1-55

[C16]

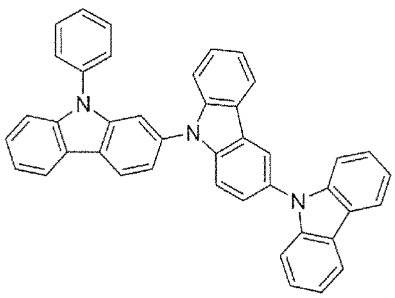

1-56

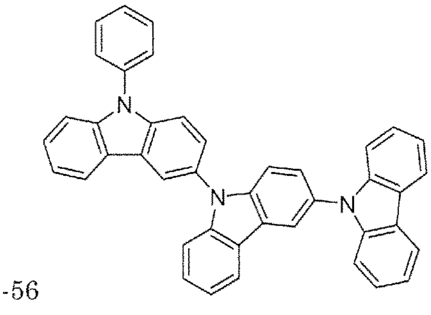

1-57

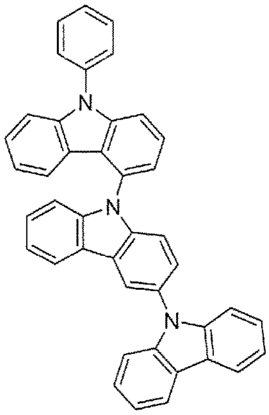

1-58

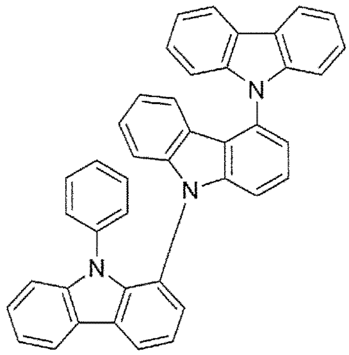

1-59

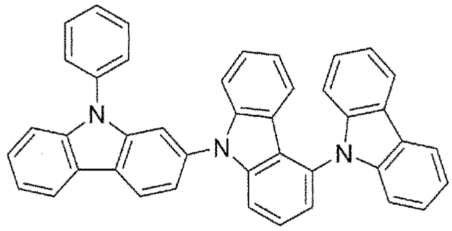

1-60

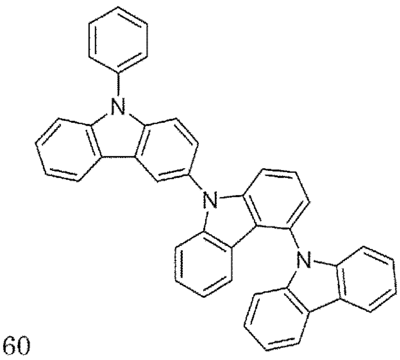

1-61

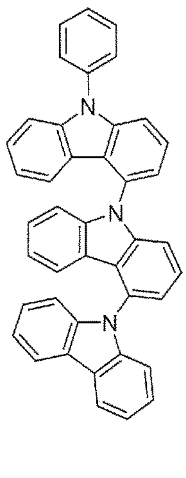

1-62

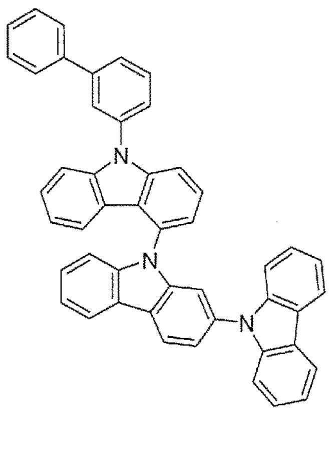

1-63

[C17]

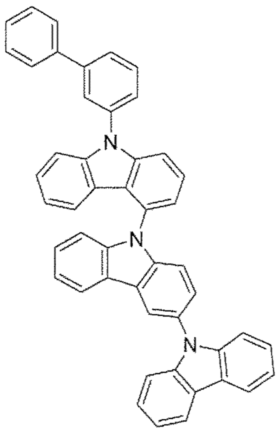

1-64

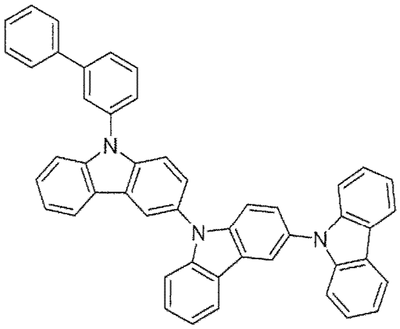

1-65

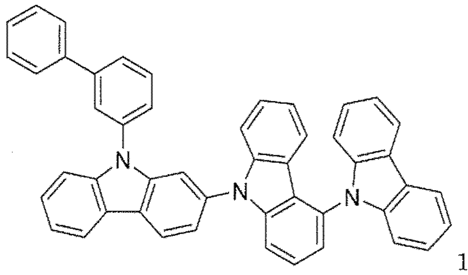

1-66

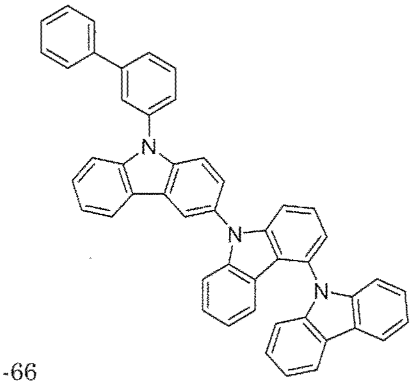

1-67

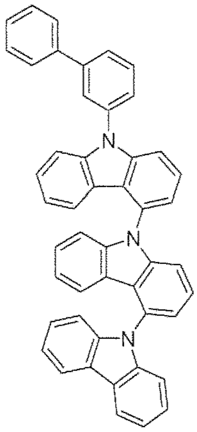

1-68

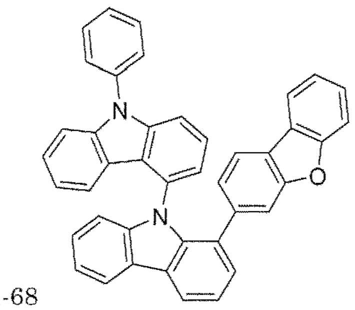

1-69

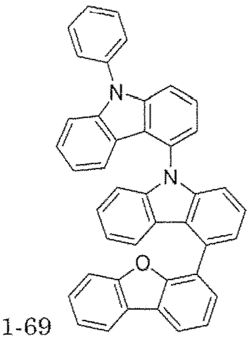

1-70

[C18]

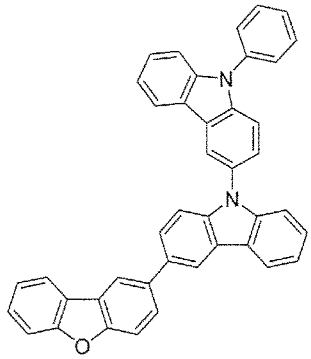
1-71

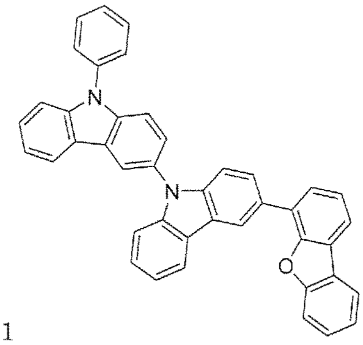
1-72

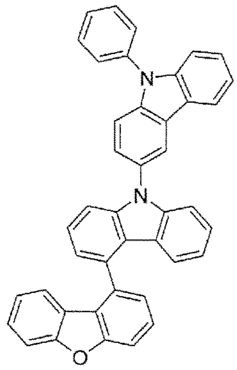
1-73

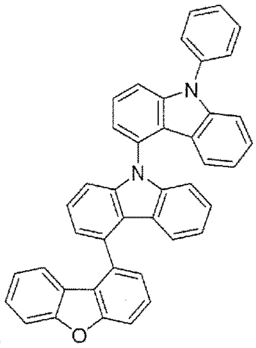
1-74

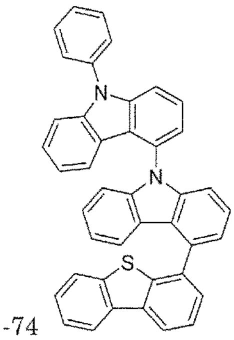
1-75

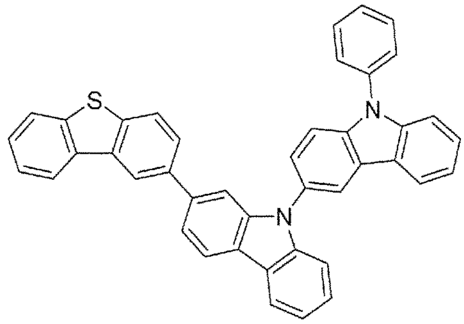
1-76

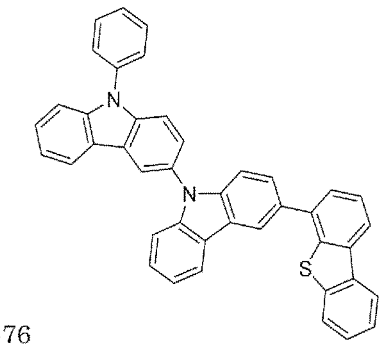
1-77

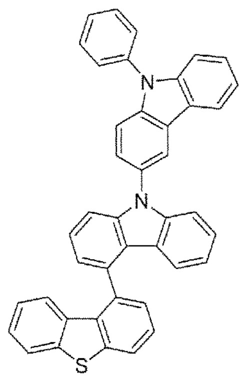
1-78

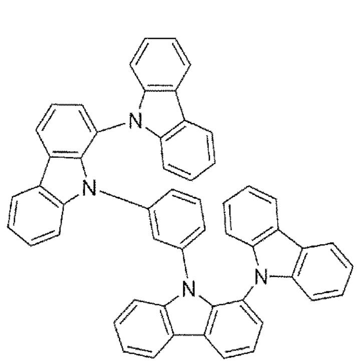
1-79

[C19]

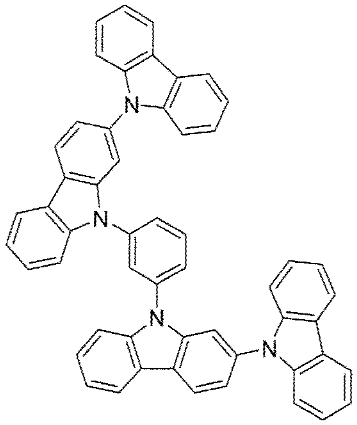
1-80

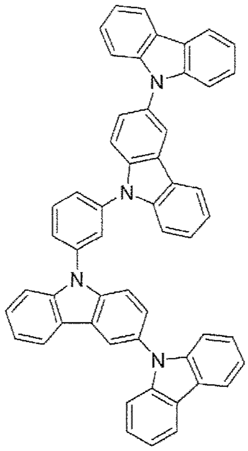
1-81

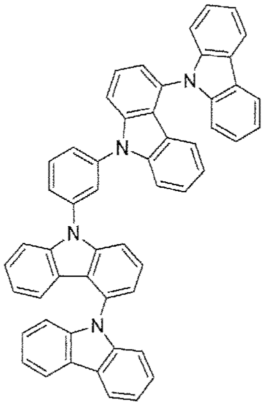
1-82

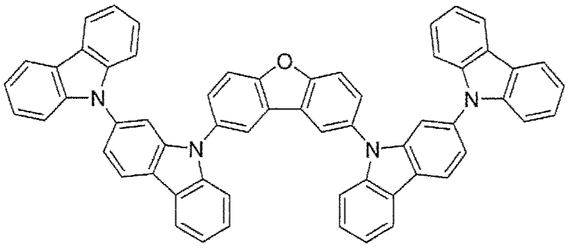
1-83

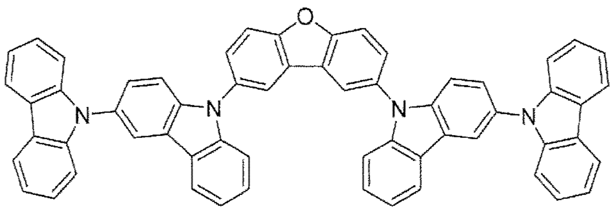
1-84

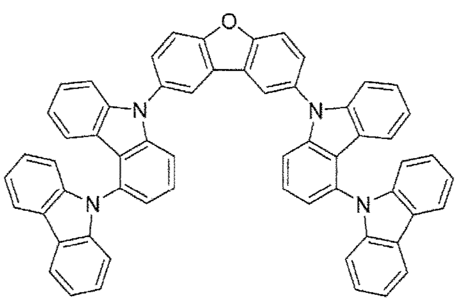
1-85

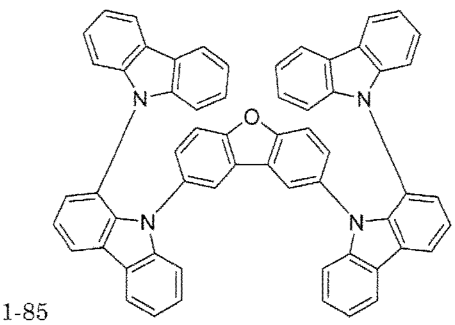
1-86

[C20]

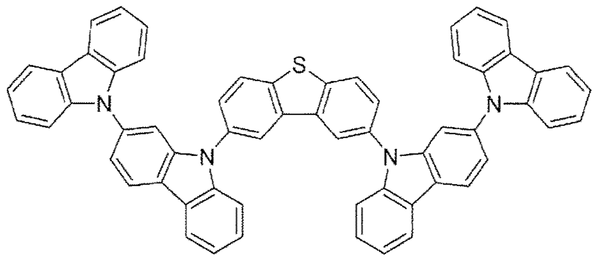

1-87

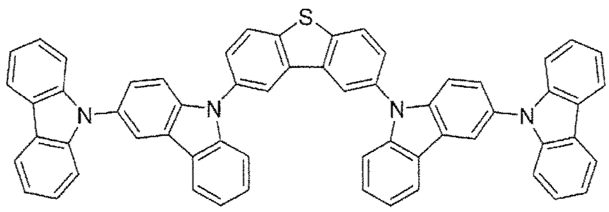

1-88

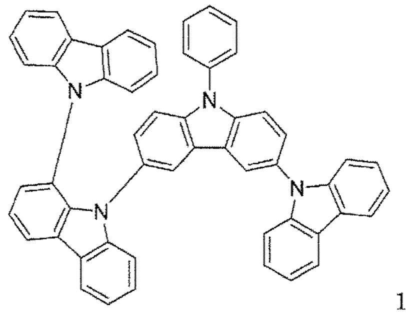

1-89

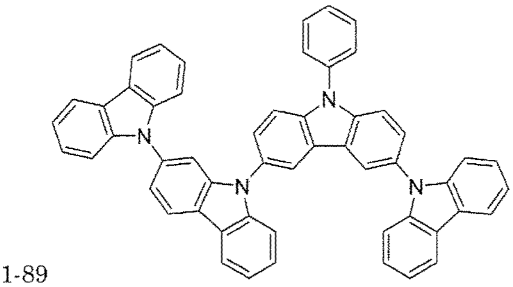

1-90

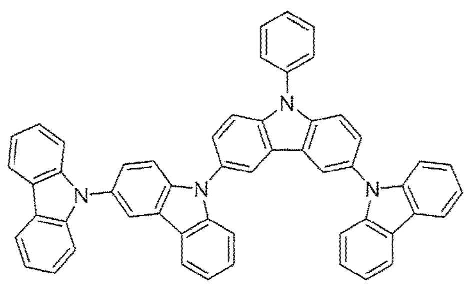

1-91

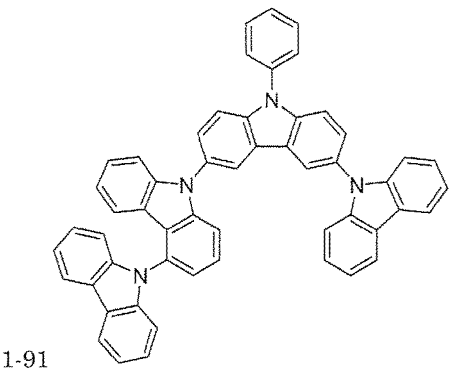

1-92

[C21]

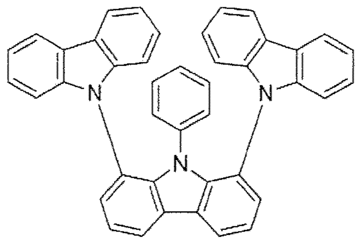
1-93

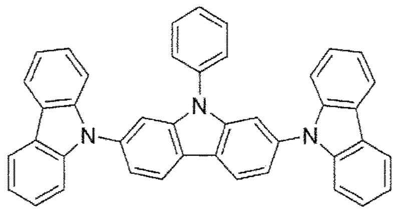
1-94

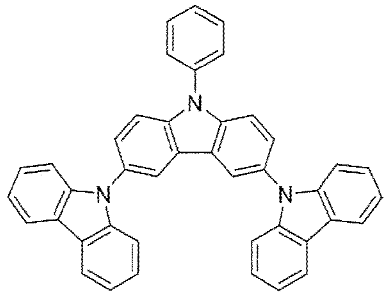
1-95

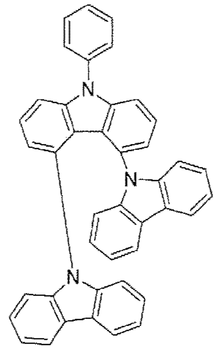
1-96

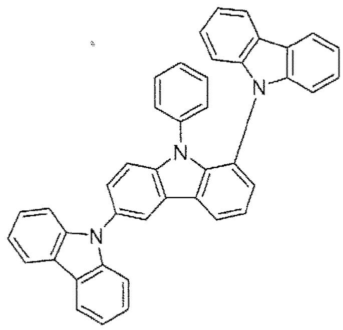
1-97

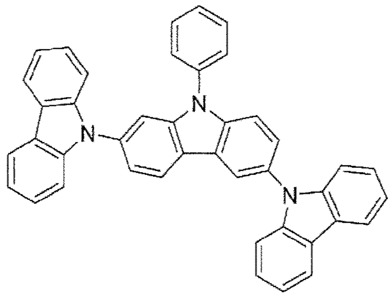
1-98

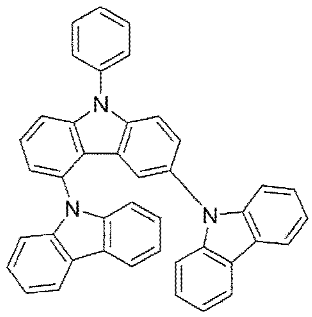
1-99

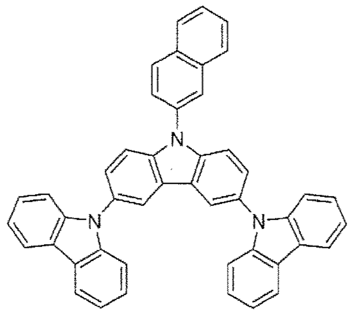
1-100

[C22]

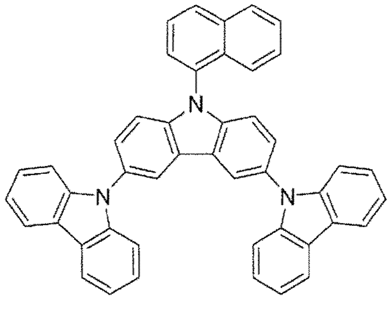
1-101

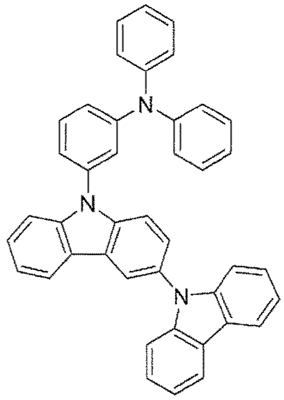
1-102

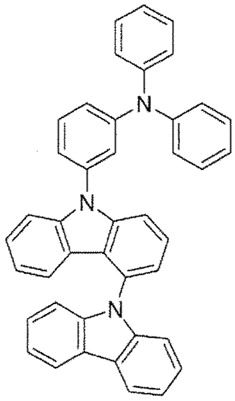
1-103

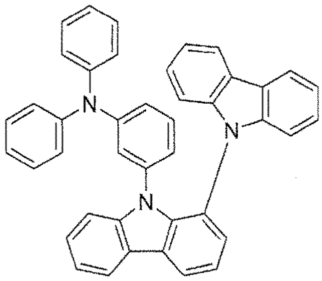
1-104

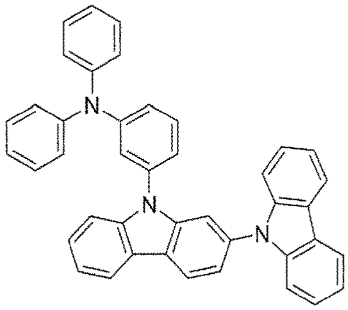
1-105

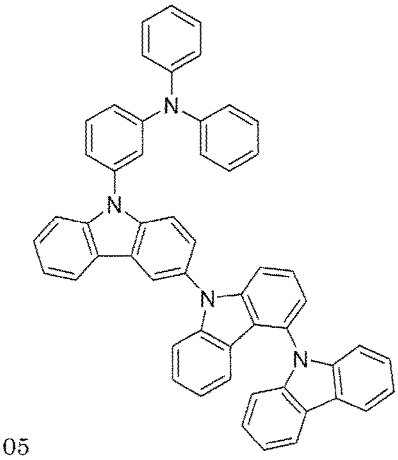
1-106

[C23]

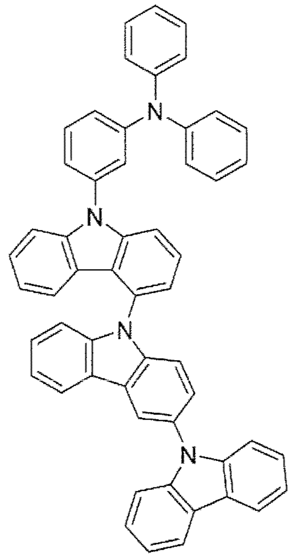

1-107

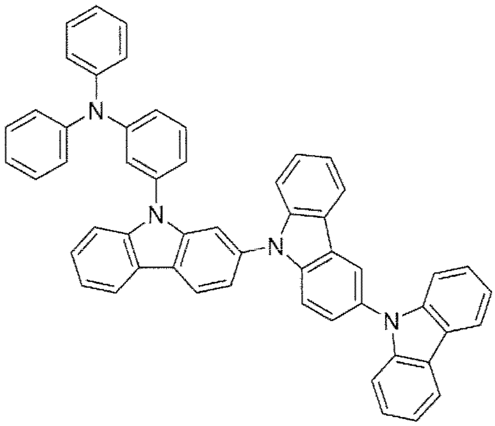

1-108

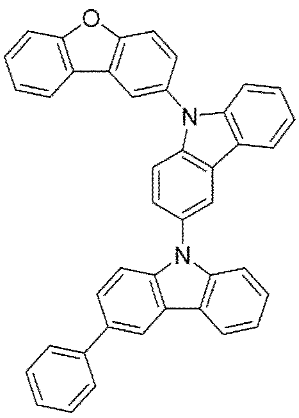

1-109

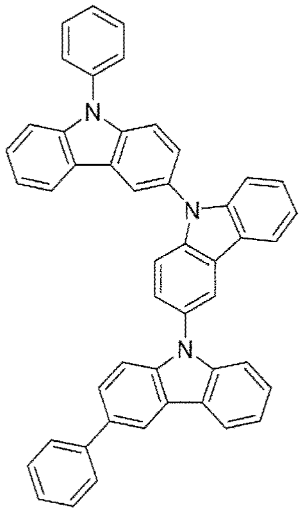

1-110

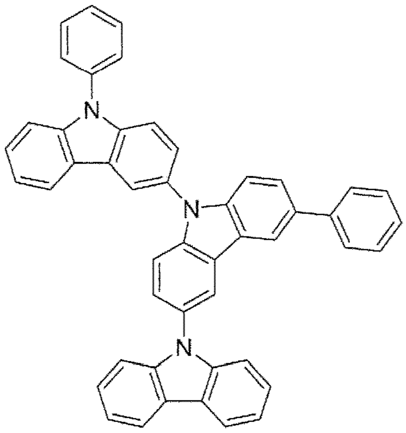

1-111

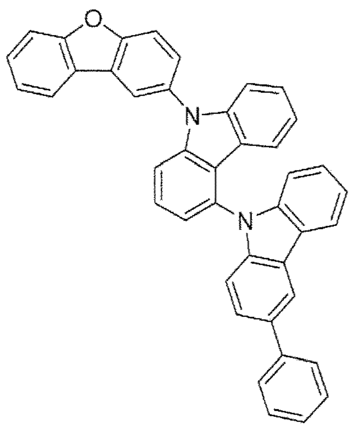

1-112

[C24]

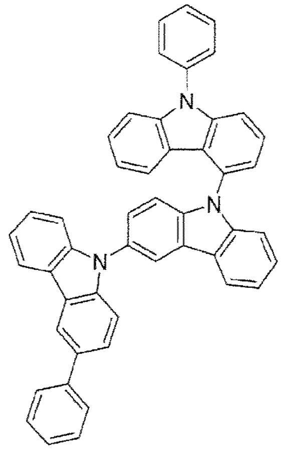

1-113

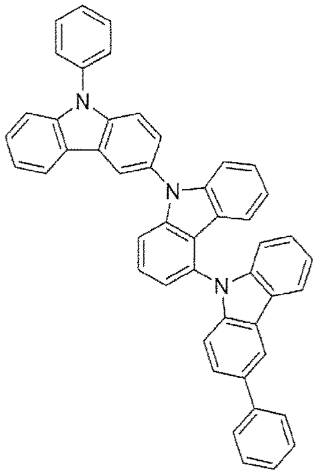

1-114

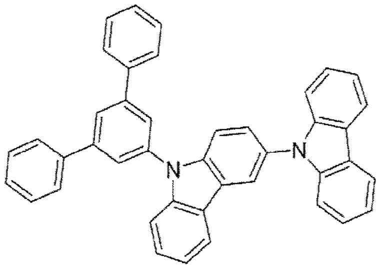

1-115

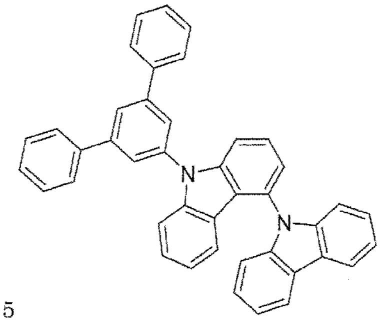

1-116

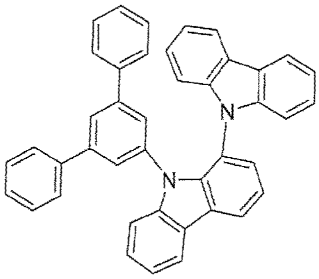

1-117

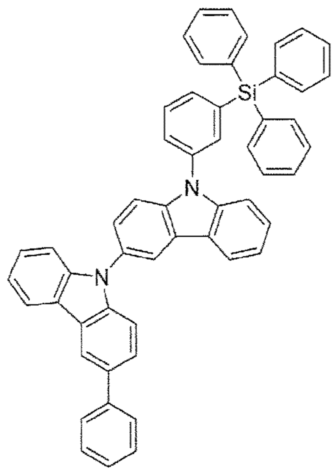

1-118

[C25]

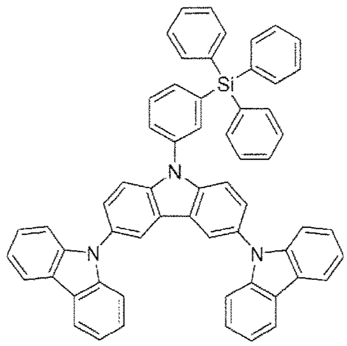

1-119

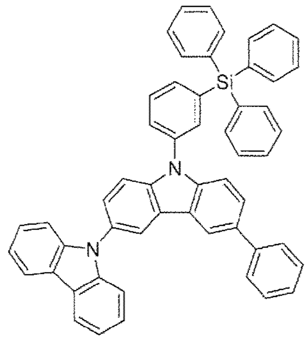

1-120

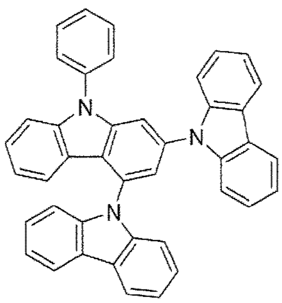

1-121

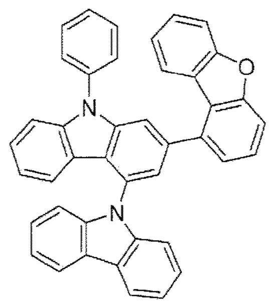

1-122

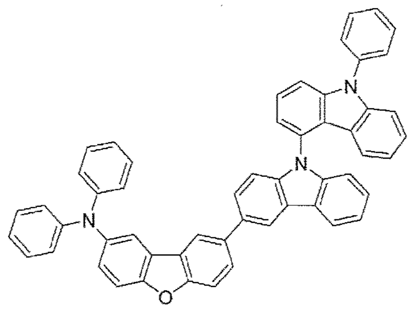

1-123

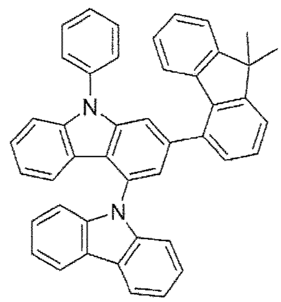

1-124

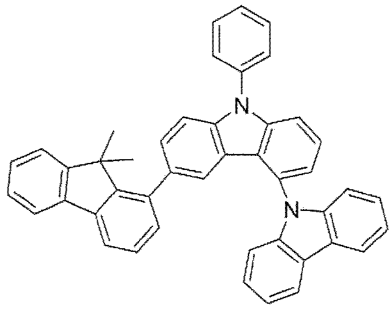

1-125

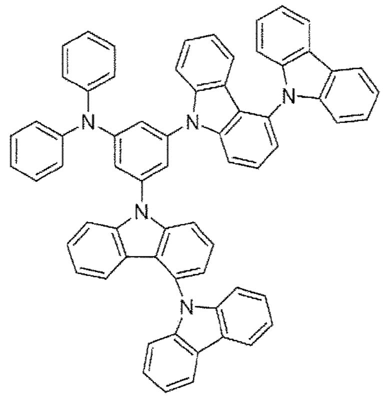

1-126

[C26]

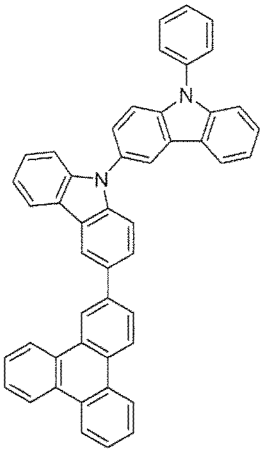

1-125a

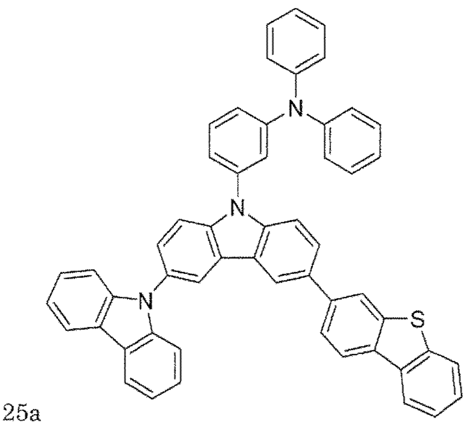

1-126a

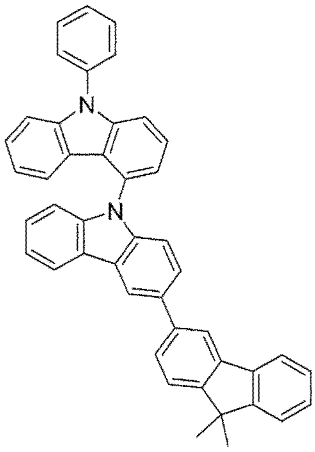

1-127

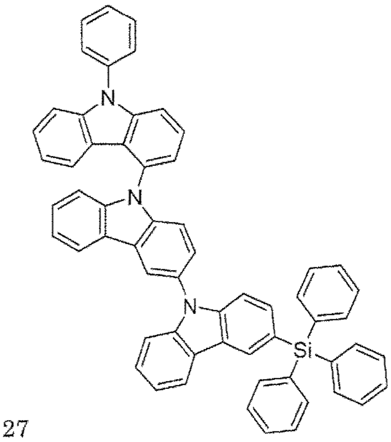

1-128

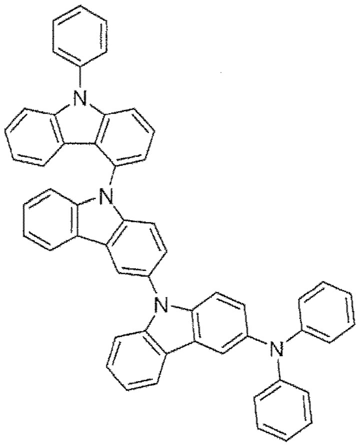

1-129

[C27]

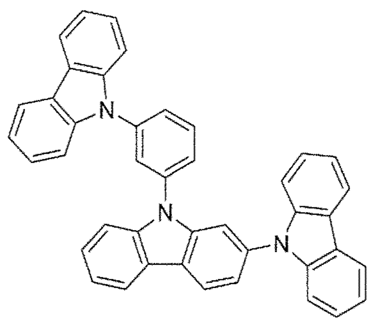
1-130

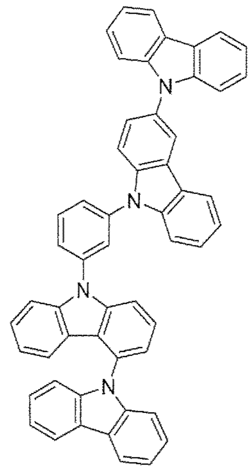
1-131

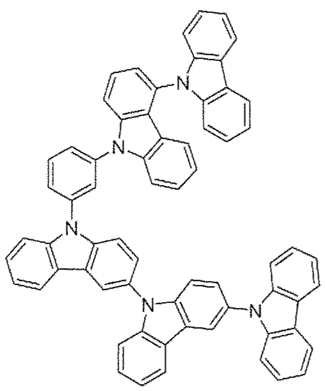
1-132

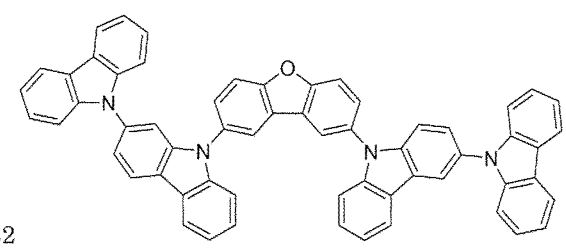
1-133

The compound represented by the general formula (2) used as the second host will be described.

In the general formula (2), $X^1$ each independently represents N or C-$R^2$, and at least one $X^1$ represents N. It is preferable that two $X^1$ represent N. It is more preferable that three $X^1$ are N, that is, the compound represented by the general formula (2) is preferably a triazine compound.

The preferred example of the general formula (2) is formula (6), formula (7) and formula (8) above, and, formula (7) is more preferred. In the general formula (2), formula (6), formula (7) and formula (8), the common symbols have the same meaning.

1, m, n, o, p, and q each independently represent an integer of 0 to 4 and preferably an integer of 0 to 2.

$Ar^2$ each independently represents hydrogen, a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group formed by linking 2 to 8 aromatic rings thereof. Preferably, $Ar^2$ represents a substituted or unsubstituted aromatic hydrocarbon group having 6 to 12 carbon atoms, a substituted or unsubstituted aromatic heterocyclic group having 3 to 12 carbon atoms, or a substituted or unsubstituted linked aromatic group formed by linking 2 to 6 aromatic rings thereof. More preferably, $Ar^2$ represents a substituted or unsubstituted aromatic hydrocarbon group having 6 to 10 carbon atoms, a substituted or unsubstituted aromatic heterocyclic group having 6 to 12 carbon atoms, or a substituted or unsubstituted linked aromatic group formed by linking 2 to 4 aromatic rings thereof. Provided that at least one $Ar^2$ is the aforementioned aromatic hydrocarbon group, the aromatic heterocyclic group or the linked aromatic group.

When $Ar^2$ is an unsubstituted aromatic hydrocarbon group or an unsubstituted aromatic heterocyclic group, specific examples thereof are the same as described for $Ar^1$ or $R^1$ above. Examples of the unsubstituted linked aromatic group are the same as described for $Ar^1$ above.

Preferably, $Ar^2$ is a group produced by removing one hydrogen atom from benzene, naphthalene, acenaphthene, acenaphthylene, azulene, pyridine, triazine, dibenzofuran, dibenzothiophene, carbazole, or a compound formed by linking 2 to 6 thereof. More preferably, $Ar^2$ is a group produced by removing one hydrogen atom from benzene, carbazole, dibenzofuran, dibenzothiophene, or a compound formed by linking 2 to 4 benzene rings, are included.

$R^2$ each independently represents hydrogen, deuterium, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms. Preferably, $R^2$ is hydrogen, a substituted or unsubstituted aromatic hydrocarbon group having 6 to 12 carbon atoms, or a substituted or unsubstituted aromatic heterocyclic group having 3 to 15 carbon atoms. More preferably, $R^2$ is an aromatic hydrocarbon group having 6 to 10 carbon atoms.

In formula (6) and formula (7), $R^5$ and $R^6$ each independently represent deuterium, an aliphatic hydrocarbon group having 1 to 10 carbon atoms, a triaryl silyl group having 18 to 36 carbon atoms, a substituted or unsubstituted aromatic hydrocarbon group having 6 to 18 carbon atoms, or a substituted or unsubstituted aromatic heterocyclic group having 3 to 17 carbon atoms. $R^5$ and $R^6$ are preferably a substituted or unsubstituted aromatic hydrocarbon group having 6 to 12 carbon atoms, or a substituted or unsubstituted aromatic heterocyclic group having 3 to 15 carbon atoms. More preferably, $R^5$ and $R^6$ are each an aromatic hydrocarbon group having 6 to 10 carbon atoms or an aromatic heterocyclic group having 3 to 15 carbon atoms.

When $R^2$, $R^5$ and $R^6$ represent an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms, specific examples thereof are the same as described for $R^1$. Preferably, $R^2$, $R^5$ and $R^6$ are a group produced by removing one hydrogen atom from benzene, naphthalene, acenaphthene, acenaphthylene, azulene, dibenzofuran, dibenzothiophene, or carbazole. More preferably, $R^2$, $R^5$ and $R^6$ are each a group produced by removing one hydrogen atom from benzene, naphthalene or carbazole.

Specific examples of the compounds represented by the general formula (2), formula (6), formula (7) and formula (8) are shown below, but the compounds are not limited to these exemplified compounds.

[C28]

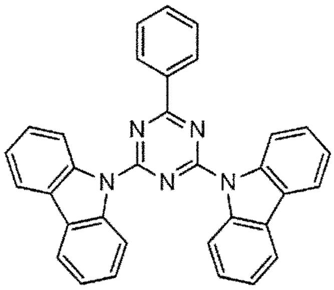

2-1

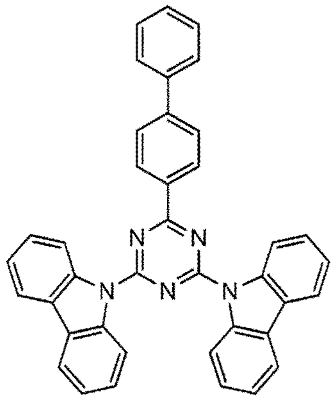

2-2

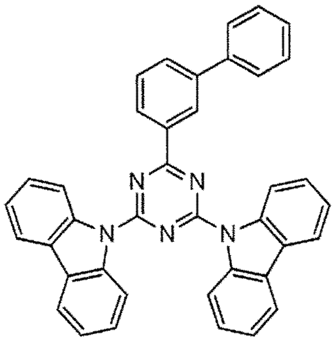

2-3

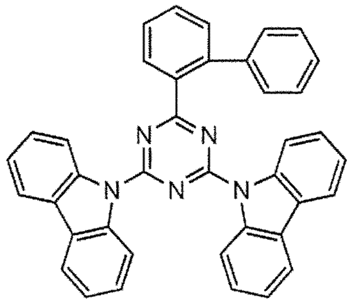

2-4

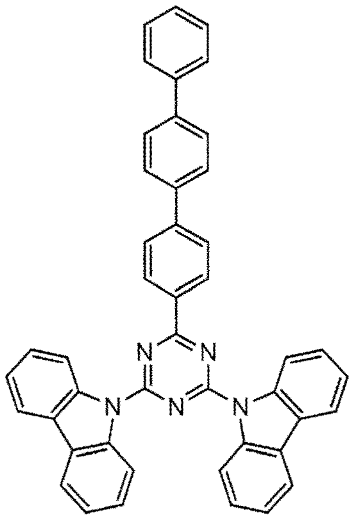

2-5

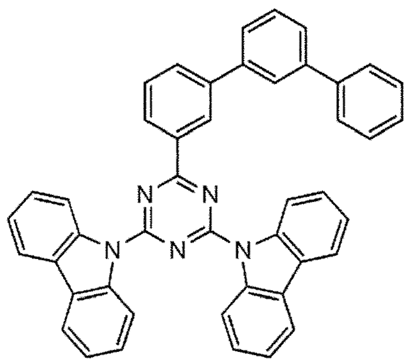

2-6

[C29]

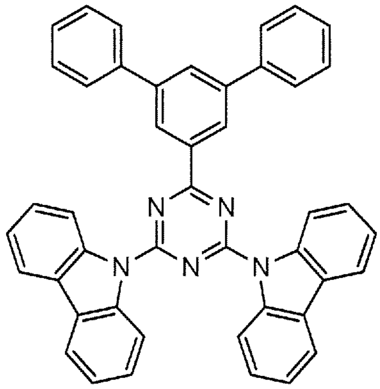

2-7

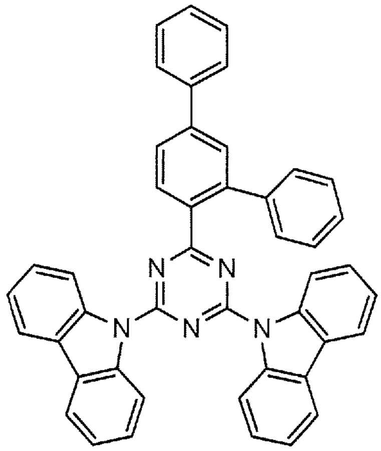

2-8

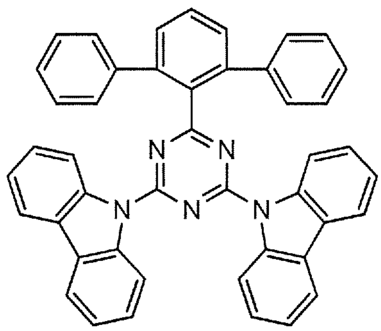

2-9

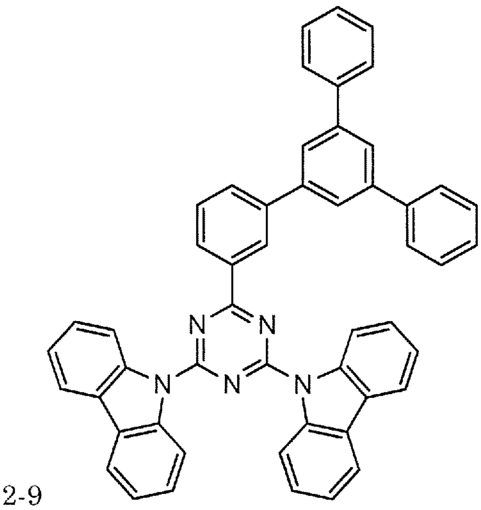

2-10

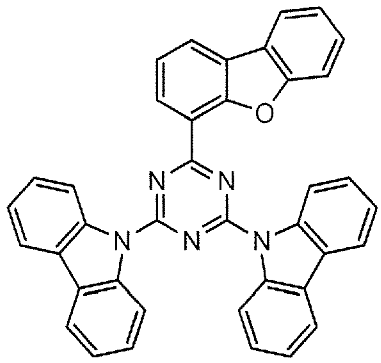

2-11

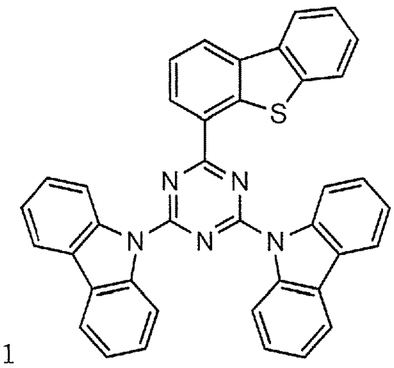

2-12

[C30]

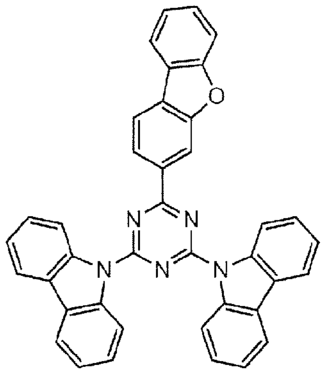
2-13

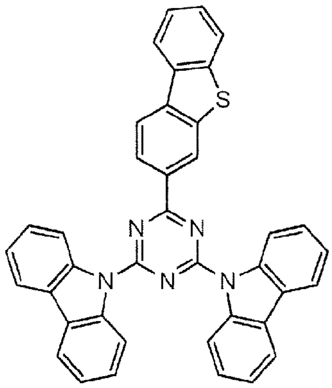
2-14

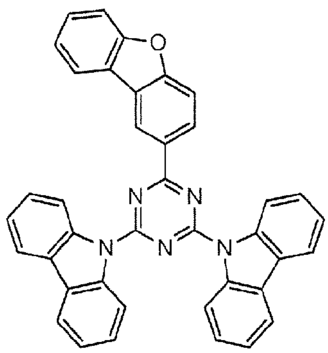
2-15

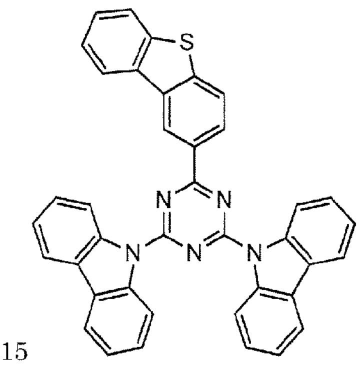
2-16

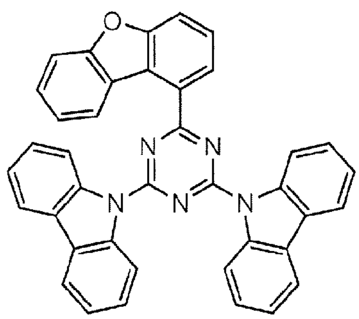
2-17

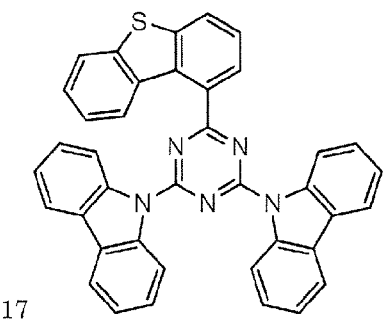
2-18

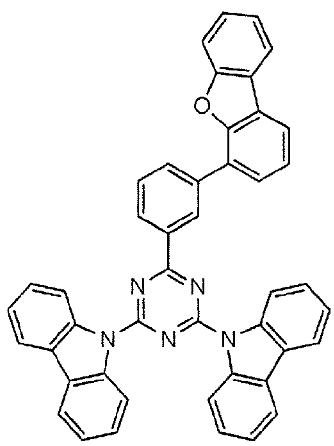
2-19

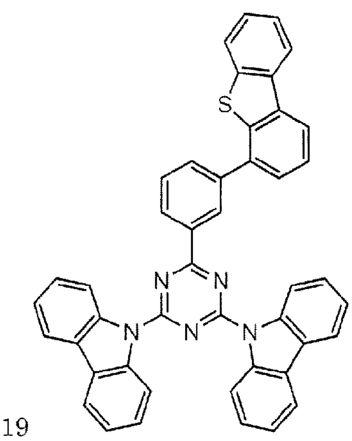
2-20

[C31]

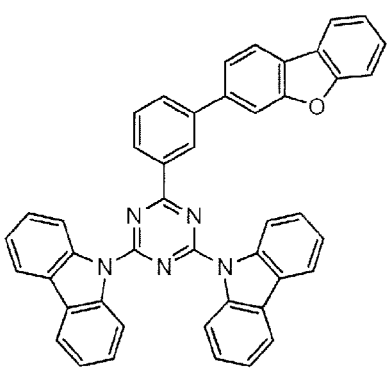

2-21

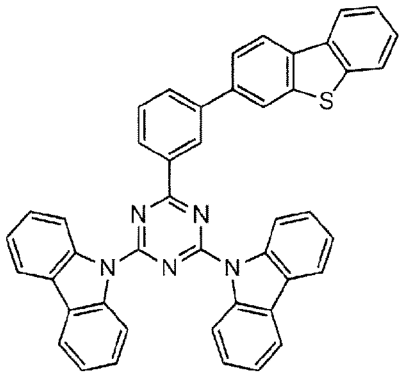

2-22

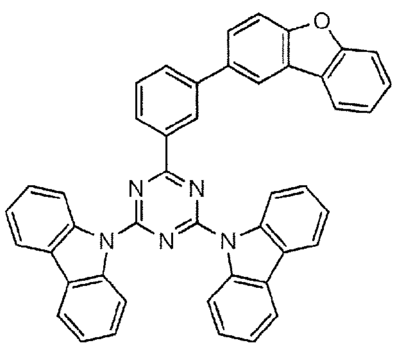

2-23

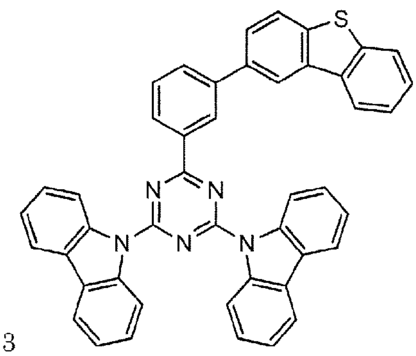

2-24

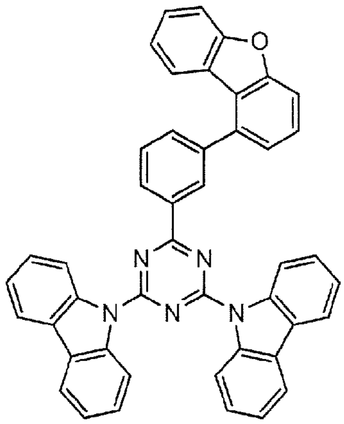

2-25

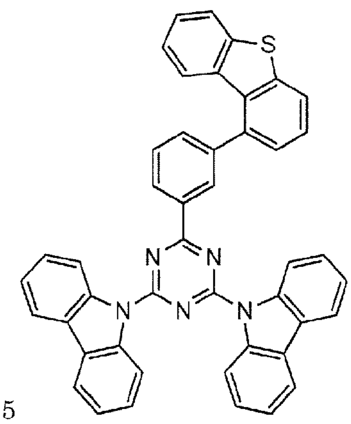

2-26

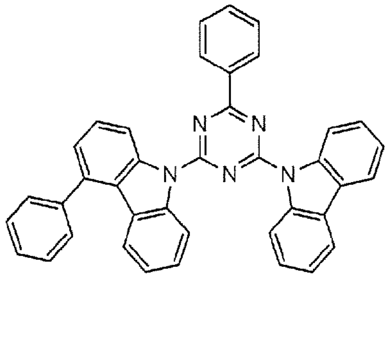

2-27

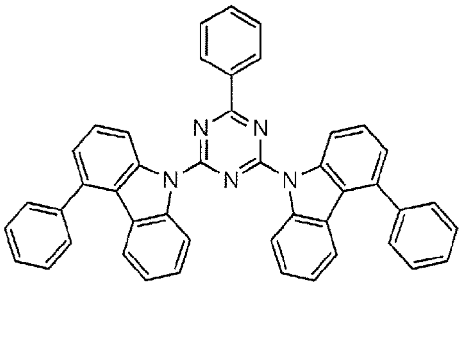

2-28

[C32]

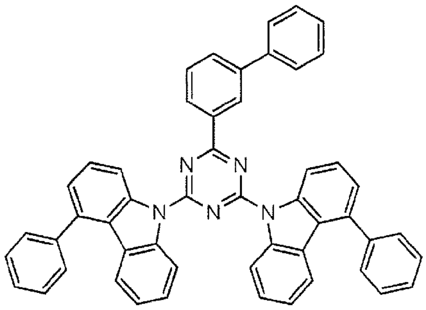

2-29

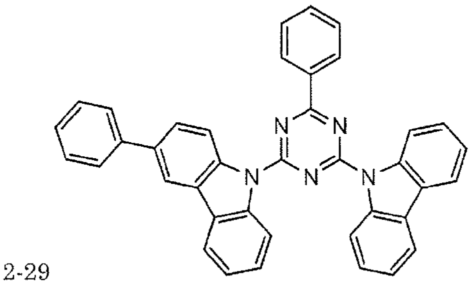

2-30

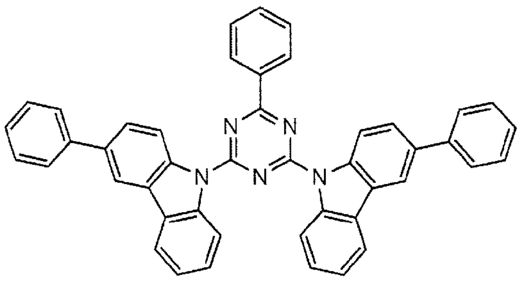

2-31

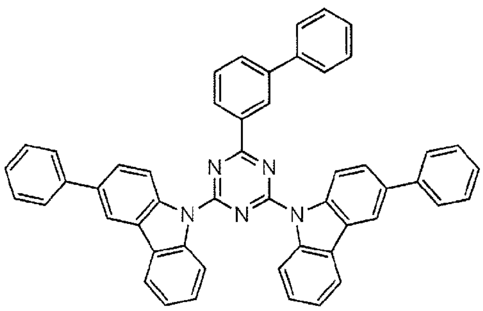

2-32

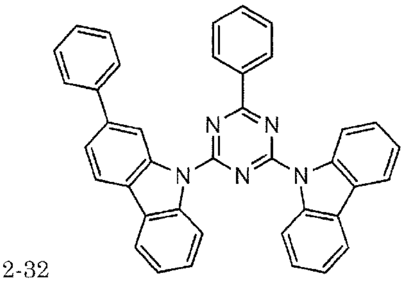

2-33

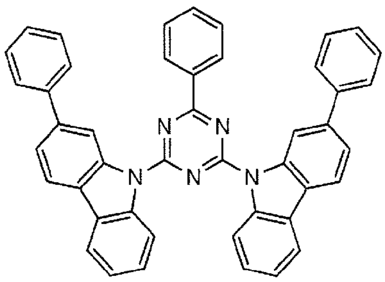

2-34

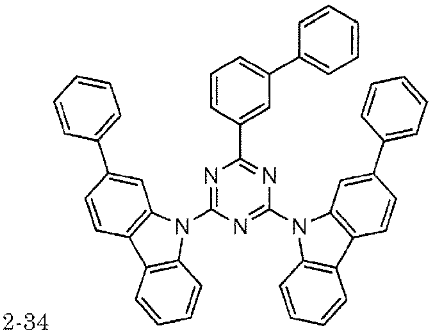

2-35

[C33]

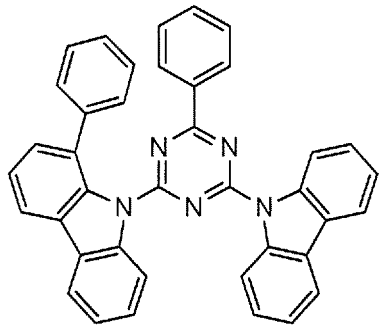

2-36

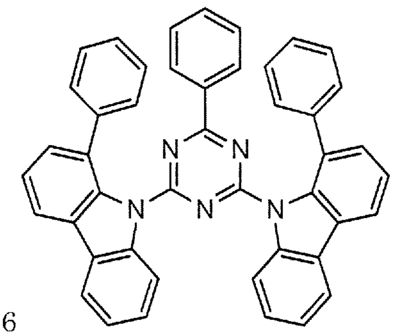

2-37

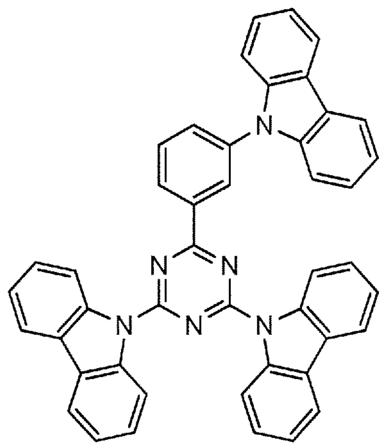

2-38

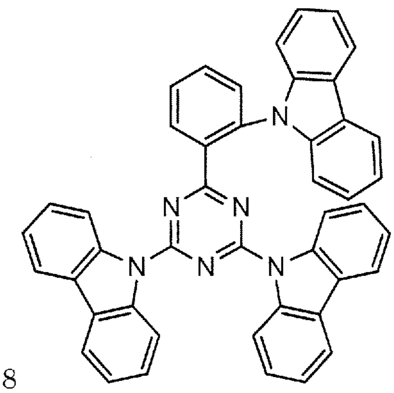

2-39

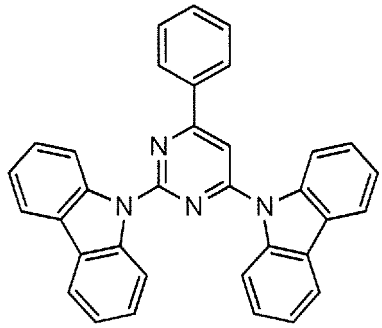

2-40

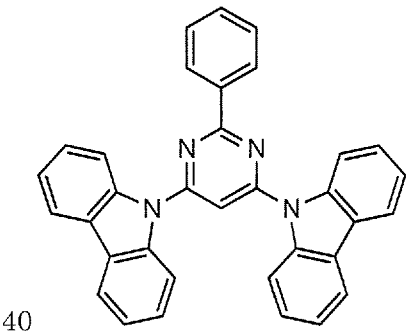

2-41

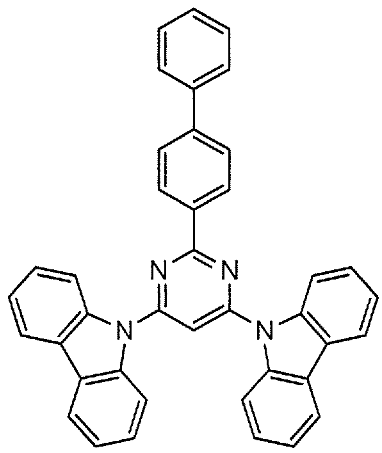

2-42

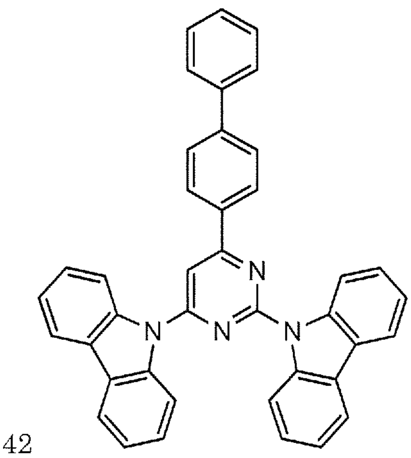

2-43

[C34]

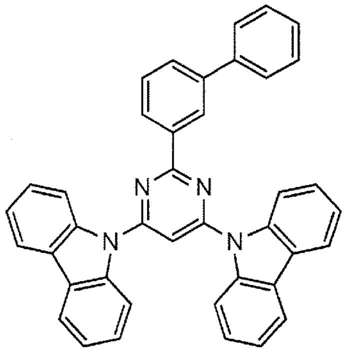
2-44

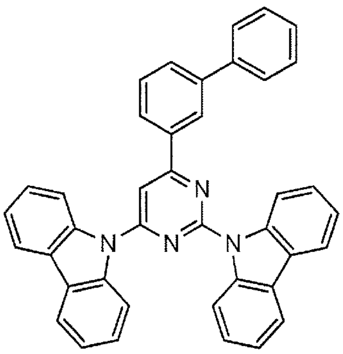
2-45

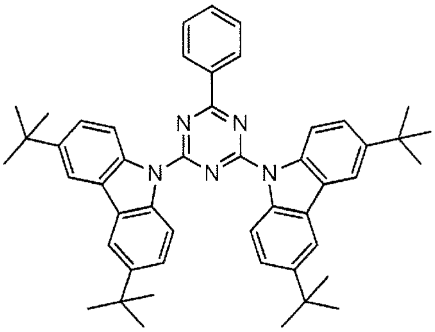
2-46

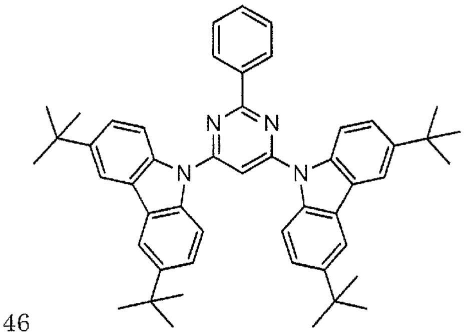
2-47

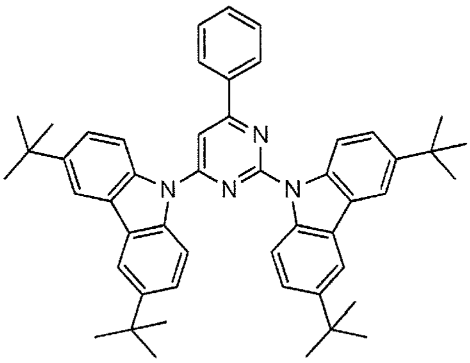
2-48

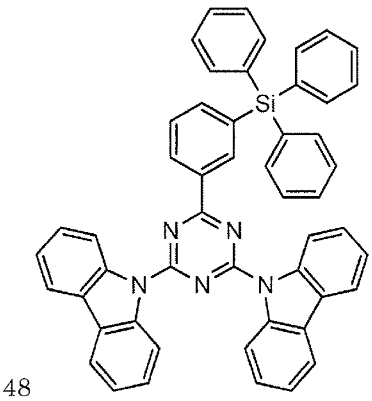
2-49

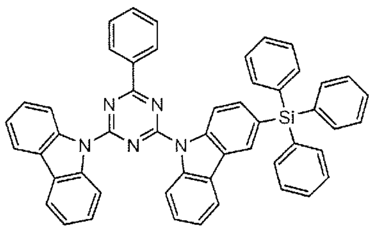
2-50

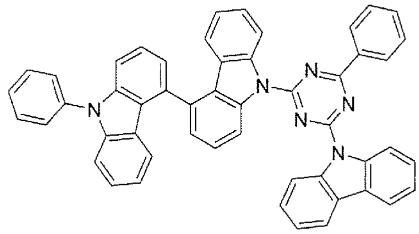
2-51

[C35]

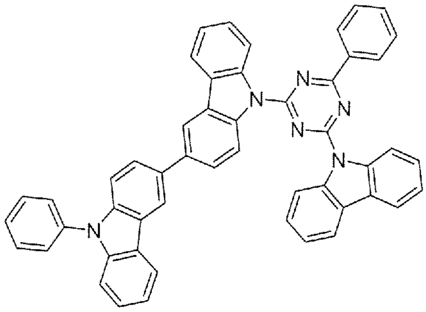

2-52

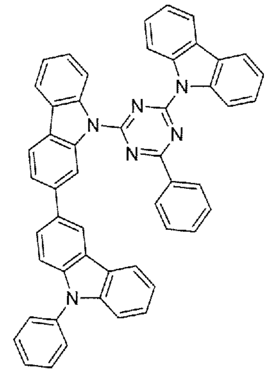

2-53

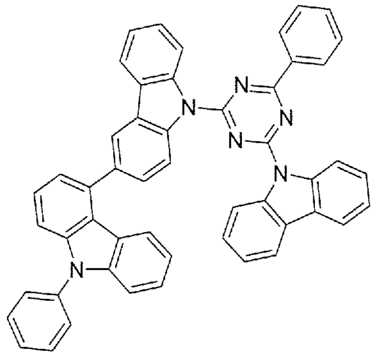

2-54

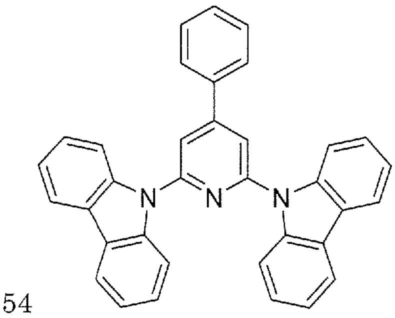

2-55

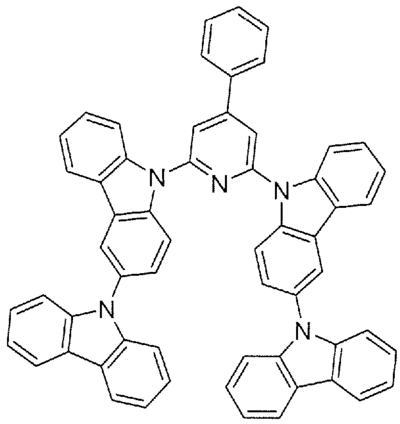

2-56

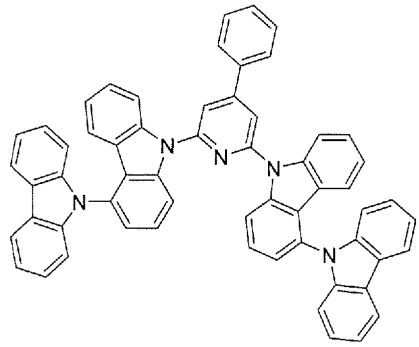

2-57

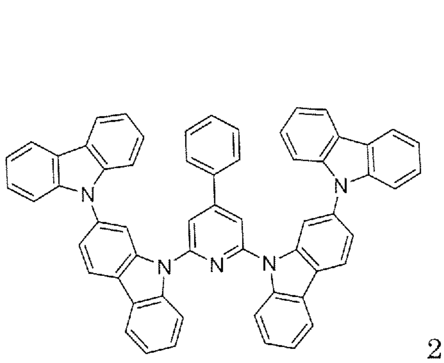

2-58

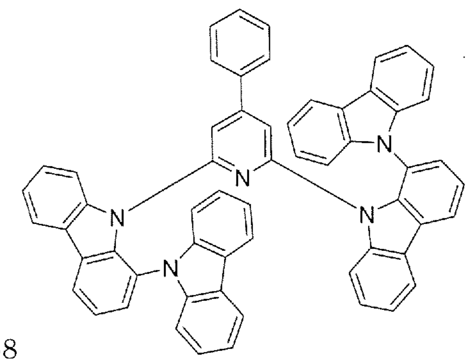

2-59

[C36]

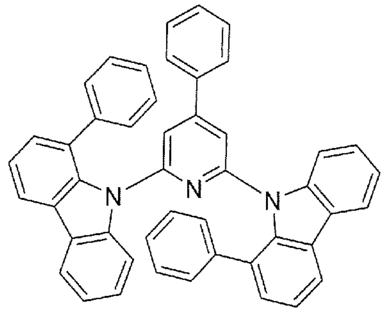

2-60

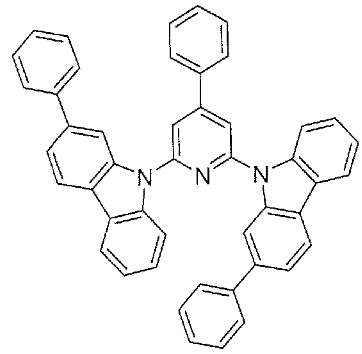

2-61

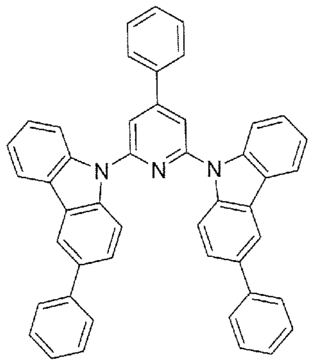

2-62

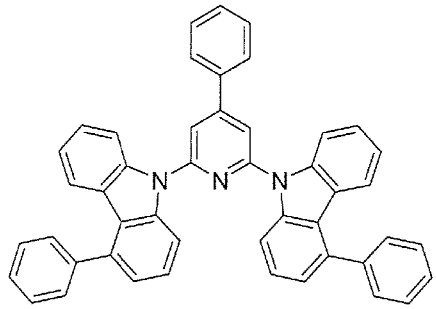

2-63

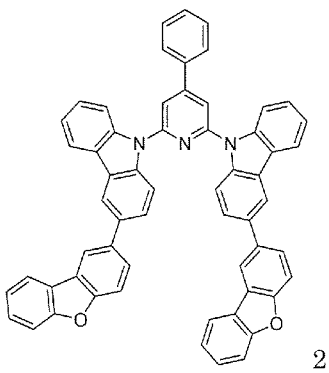

2-64

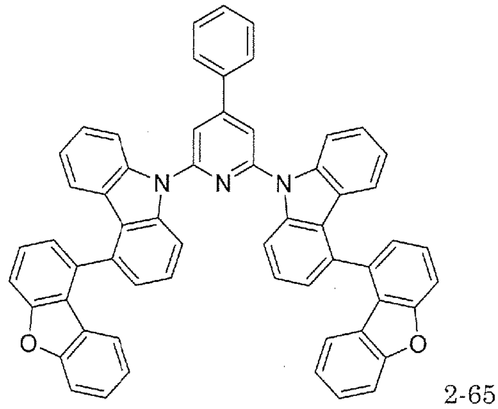

2-65

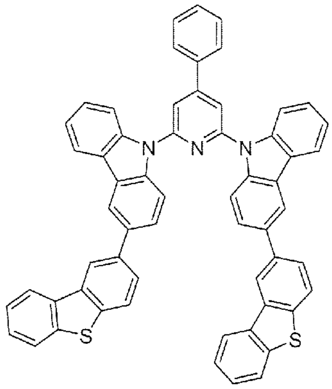

2-66

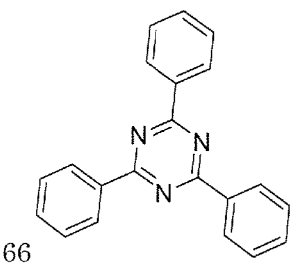

2-67

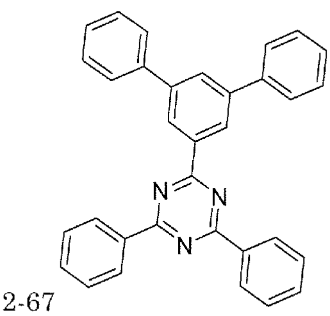

2-68

[C37]

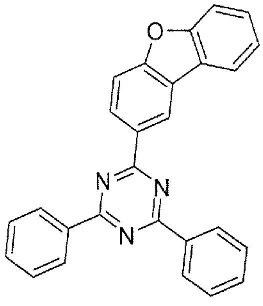
2-69

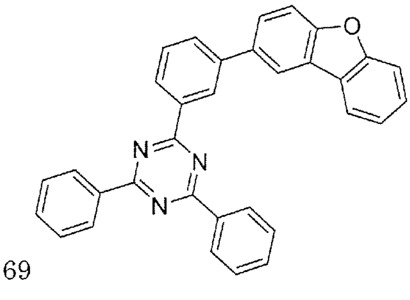
2-70

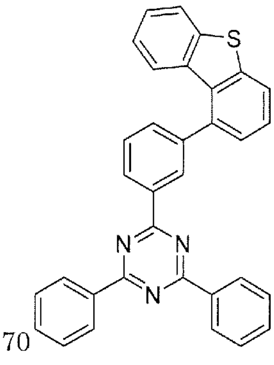
2-71

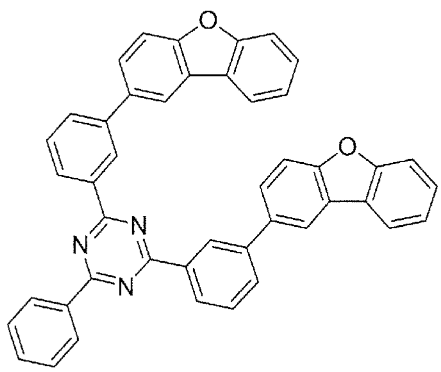
2-72

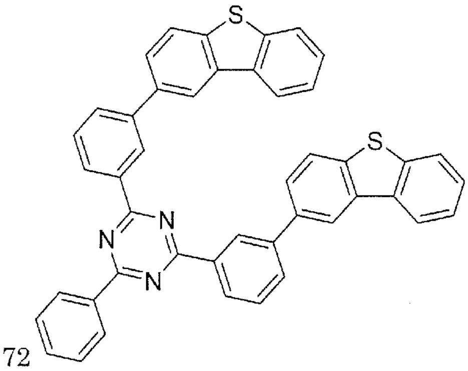
2-73

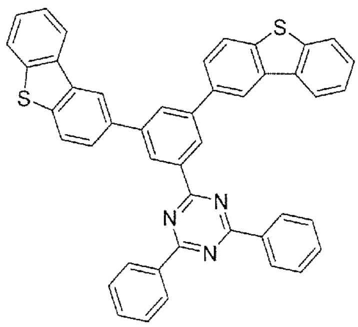
2-74

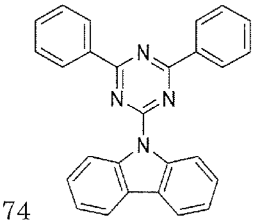
2-75

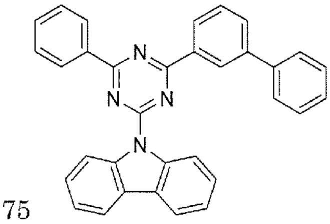
2-76

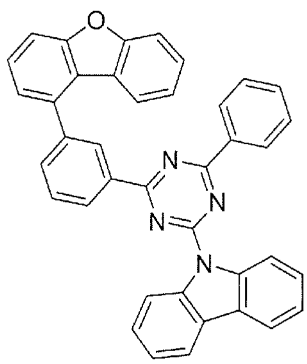
2-77

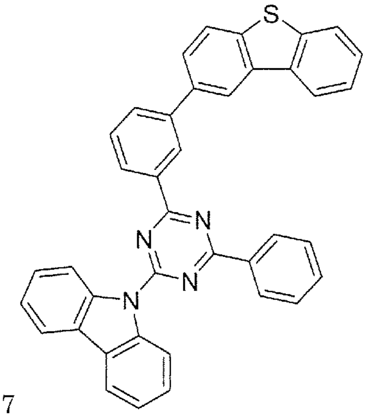
2-78

[C38]

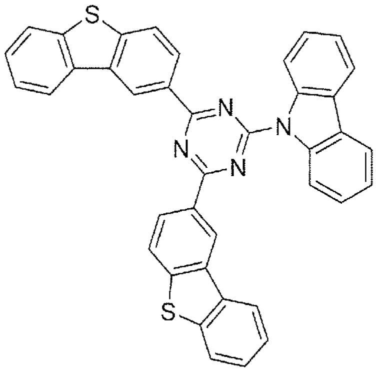

2-79

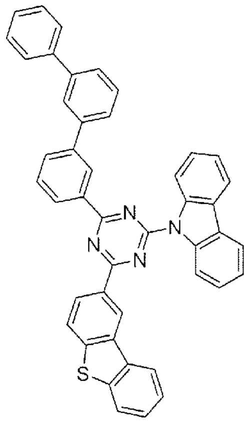

2-80

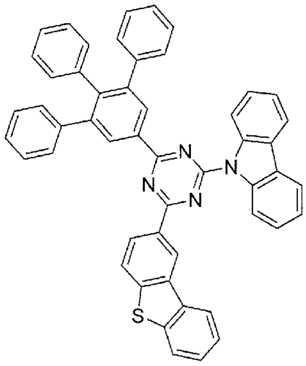

2-81

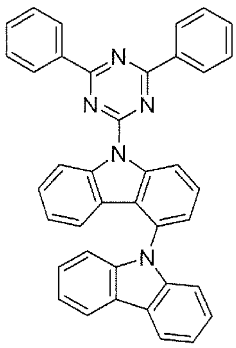

2-82

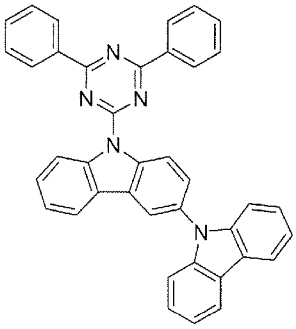

2-83

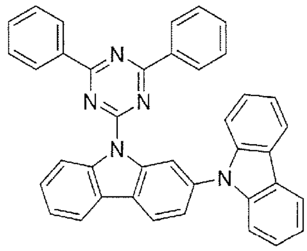

2-84

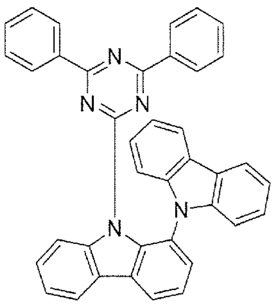

2-85

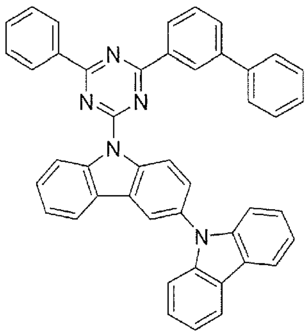

2-86

[C39]

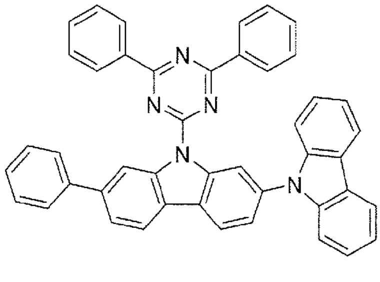

2-87

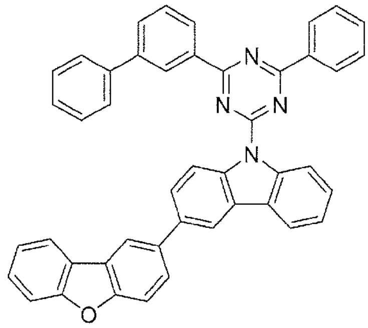

2-88

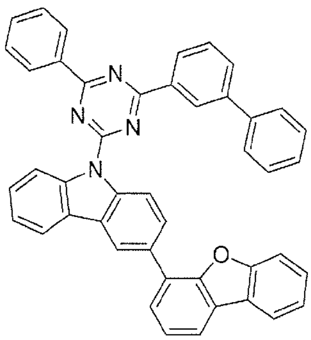

2-89

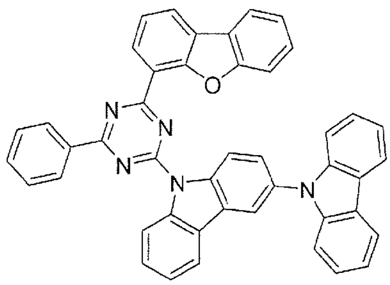

2-90

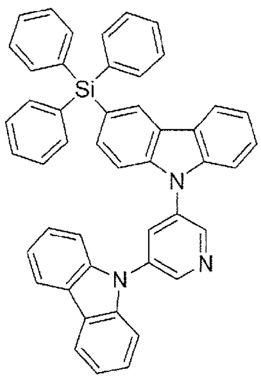

2-91

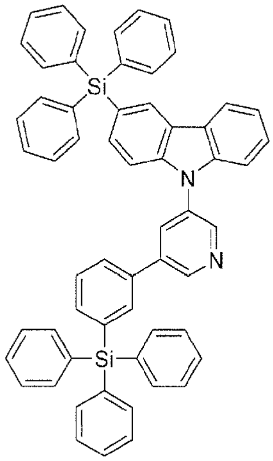

2-92

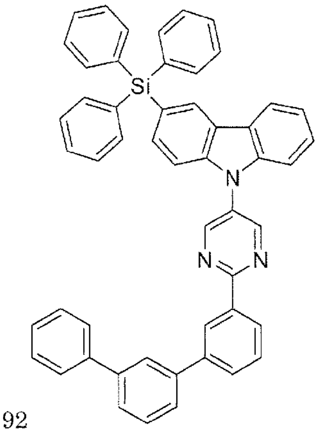

2-93

[C40]

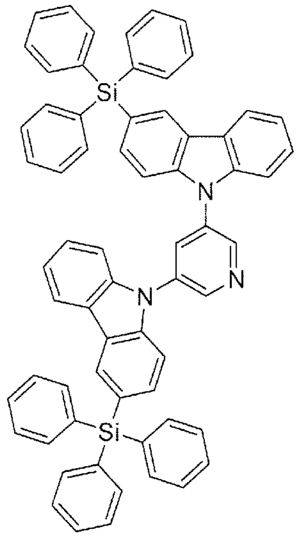

2-94

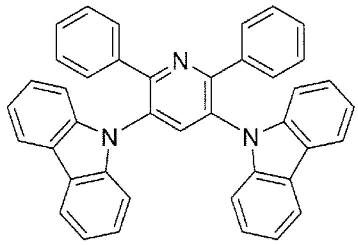

2-95

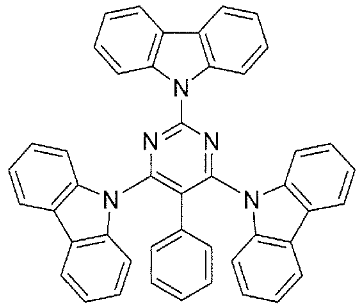

2-96

The light emitting dopant used in the organic EL of the present invention is a polycyclic aromatic compound represented by the aforementioned general formula (4). Preferably, the light emitting dopant is the boron-containing polycyclic aromatic compound represented by the aforementioned formula (5).

In the general formula (4), the D ring, E ring, F ring, G ring, and H ring each independently represent a substituted or unsubstituted aromatic hydrocarbon ring having 6 to 24 carbon atoms, or a substituted or unsubstituted aromatic heterocyclic ring having 3 to 17 carbon atoms and preferably a substituted or unsubstituted aromatic hydrocarbon ring having 6 to 20 carbon atoms, or a substituted or unsubstituted aromatic heterocyclic ring having 3 to 15 carbon atoms. Since the D ring to H ring are aromatic hydrocarbon rings or aromatic heterocyclic rings as described above, they are therefore also referred to as aromatic rings.

Specific examples of the unsubstituted aromatic ring include rings of benzene, naphthalene, acenaphthene, acenaphthylene, azulene, anthracene, chrysene, pyrene, phenanthrene, triphenylene, fluorene, benzo[a]anthracene, pyridine, pyrimidine, triazine, thiophene, isothiazole, thiazole, pyridazine, pyrrole, pyrazole, imidazole, pyrazine, furan, isoxazole, quinoline, isoquinoline, quinoxaline, quinazoline, phthalazine, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, and carbazole. The aromatic ring is preferably a benzene ring, a naphthalene ring, an anthracene ring, a triphenylene ring, a phenanthrene ring, a pyrene ring, a pyridine ring, a dibenzofuran ring, a dibenzothiophene ring, or a carbazole ring.

In the D ring, E ring, F ring, G ring, and H ring, the aromatic hydrocarbon ring or the aromatic heterocyclic ring may have a substituent, and the substituent each independently represents a cyano group, deuterium, a diarylamino group having 12 to 44 carbon atoms, an arylheteroarylamino group having 12 to 44 carbon atoms, a diheteroarylamino group having 12 to 44 carbon atoms, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms. The substituent is preferably a diarylamino group having 12 to 36 carbon atoms, an arylheteroarylamino group having 12 to 36 carbon atoms, a diheteroarylamino group having 12 to 36 carbon atoms, an aromatic hydrocarbon group having 6 to 12 carbon atoms, or an aromatic heterocyclic ring having 3 to 15 carbon atoms. The substituent is more preferably a diarylamino group having 12 to 24 carbon atoms, an arylheteroaryl

group having 12 to 24 carbon atoms, a diheteroarylamino group having 12 to 24 carbon atoms, an aromatic hydrocarbon group having 6 to 10 carbon atoms, or an aromatic heterocyclic group having 3 to 12 carbon atoms. Here, when the substituent is an aliphatic hydrocarbon group having 1 to 10 carbon atoms, it may be linear, branched, or cyclic.

When the substituent representing the above diarylamino group having 12 to 44 carbon atoms, an arylheteroarylamino group having 12 to 44 carbon atoms, a diheteroarylamino group having 12 to 44 carbon atoms, or an aliphatic hydrocarbon group having 1 to 10 carbon atoms, specific examples thereof include diphenylamino, dibiphenylamino, phenylbiphenylamino, naphthylphenylamino, dinaphthylamino, dianthranylamino, diphenanthrenylamino, dipyrenylamino, dibenzofuranylphenylamino, dibenzofuranylbiphenylamino, dibenzofuranylnaphthylamino, dibenzofuranylanthranylamino, dibenzofuranylphenanthrenylamino, dibenzofuranylpyrenylamino, bis-dibenzofuranylamino, carbazolylphenylamino, carbazolylnaphthylamino, carbazolylanthranylamino, carbazolylphenanthrenylamino, carbazolylpyrenylamino, dicarbazolylamino, methyl, ethyl, propyl, butyl, pentyl, hexyl, heptyl, octyl, and nonyl.

$R^3$ is preferably diphenylamino, dibiphenylamino, phenylbiphenylamino, naphthylphenylamino, dinaphthylamino, dianthranylamino, diphenanthrenylamino, or dipyrenylamino. $R^3$ is more preferably diphenylamino, dibiphenylamino, phenylbiphenylamino, naphthylphenylamino, dinaphthylamino, dibenzofuranylphenylamino, or carbazolylphenylamino.

In the general formula (4), $Y^1$ is B, P, P=O, P=S, Al, Ga, As, Si-$R^3$ or Ge-$R^3$, preferably B, P, P=O, or P=S, and more preferably B.

$R^3$ is each independently an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms.

Preferably, $R^3$ is an aliphatic hydrocarbon group having 1 to 8 carbon atoms, a substituted or unsubstituted aromatic hydrocarbon group having 6 to 12 carbon atoms, or a substituted or unsubstituted aromatic heterocyclic group having 3 to 15 carbon atoms. More preferably, $R^3$ is a substituted or unsubstituted aromatic hydrocarbon group having 6 to 10 carbon atoms or a substituted or unsubstituted aromatic heterocyclic group having 3 to 12 carbon atoms.

When $R^3$ is an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms, specific examples thereof are the same as described for $R^1$ in the general formula (1).

$X^2$ is each independently O, N-$Ar^3$, S or Se, preferably O, N-$Ar^3$ or S, and more preferably O or N-$Ar^3$.

$Ar^3$ is each independently a substituted or unsubstituted aromatic hydrocarbon group having 6 to 18 carbon atoms, a substituted or unsubstituted aromatic heterocyclic group having 3 to 17 carbon atoms, or a linked aromatic group formed by linking 2 to 8 thereof, and it is preferably a phenyl group, a biphenyl group, or a terphenyl group.

When $Ar^3$ is an unsubstituted aromatic hydrocarbon group having 6 to 18 carbon atoms, an unsubstituted aromatic heterocyclic group having 3 to 17 carbon atoms, or a linked aromatic group formed by linking 2 to 8 thereof, specific examples thereof are the same as described for $Ar^1$ in the general formula (1).

When $Ar^3$ is a substituted aromatic hydrocarbon group having 6 to 18 carbon atoms or a substituted aromatic heterocyclic group having 3 to 17 carbon atoms, the substituent is preferably deuterium, a hydroxyl group, a sulhydryl group, a cyano group, a triaryl silyl group having 18 to 36 carbon atoms, an aliphatic hydrocarbon group having 1 to 10 carbon atoms, or a diarylamino group having 12 to 44 carbon atoms. Here, when the substituent is an aliphatic hydrocarbon group having 1 to 10 carbon atoms, it may be linear, branched, or cyclic.

Specific examples of the aforementioned substituents include cyano, methyl, ethyl, propyl, i-propyl, butyl, t-butyl, pentyl, cyclopentyl, hexyl, cyclohexyl, heptyl, octyl, nonyl, decyl, diphenylamino, naphthylphenylamino, dinaphthylamino, dianthranylamino, diphenanthrenylamino, dipyrenylamino, or triphenyl silyl. Preferably, the substituent is cyano, methyl, ethyl, propyl, butyl, pentyl, hexyl, heptyl, octyl, diphenylamino, naphthylphenylamino, or dinaphthylamino.

N-$Ar^3$ may be bonded to the aromatic ring selected from the D ring, the E ring, the F ring, the G ring, or the H ring to form a heterocyclic ring containing N. When $Ar^3$ has a substituent, N-$Ar^3$ may be bonded to the aromatic ring selected from the D ring, the E ring, the F ring, the G ring, or the H ring via the substituent to form a heterocyclic ring containing N, and at least one hydrogen atom in $Ar^3$ may be substituted with deuterium.

The aforementioned polycyclic aromatic compound may be that represented by the general formula (4) or formula (5) above.

In the general formula (4) and formula (5), common symbols have the same meaning.

In the formula (5), g and h each independently represent an integer of 0 to 4, i and j each independently represent an integer of 0 to 3, and k represents an integer of 0 to 2. Preferably, g, h, i, j, and k are independently 0 or 1.

In the formula (5), $X^3$ each independently represents N-$Ar^4$, O, or S, and at least one $X^3$ represents N-$Ar^4$. $X^3$ is preferably N-$Ar^4$ or O. $Ar^4$ has the same meaning as $Ar^3$ in the general formula (4). N-$Ar^4$ may be bonded to the aforementioned aromatic rings (benzene rings corresponding to the D ring to the H ring) to form a heterocyclic ring containing N.

$R^4$ each independently represents a cyano group, deuterium, a diarylamino group having 12 to 44 carbon atoms, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon

atoms. Preferably, $R^4$ is a diarylamino group having 12 to 36 carbon atoms, a substituted or unsubstituted aromatic hydrocarbon group having 6 to 12 carbon atoms, or a substituted or unsubstituted aromatic heterocyclic ring having 3 to 15 carbon atoms. More preferably, $R^4$ is a diarylamino group having 12 to 24 carbon atoms, a substituted or unsubstituted aromatic hydrocarbon group having 6 to 10 carbon atoms, or a substituted or unsubstituted aromatic heterocyclic group having 3 to 12 carbon atoms.

When $R^4$ represents a diarylamino group having 12 to 44 carbon atoms or an aliphatic hydrocarbon group having 1 to 10 carbon atoms, specific examples thereof include diphenylamino, dibiphenylamino, phenylbiphenylamino, naphthylphenylamino, dinaphthylamino, dianthranylamino, diphenanthrenylamino, dipyrenylamino, methyl, ethyl, propyl, butyl, pentyl, hexyl, heptyl, octyl, or nonyl. Preferably, $R^4$ is diphenylamino, dibiphenylamino, phenylbiphenylamino, naphthylphenylamino, dinaphthylamino, dianthranylamino, diphenanthrenylamino, or dipyrenylamino. More preferably, $R^4$ is diphenylamino, dibiphenylamino, phenylbiphenylamino, naphthylphenylamino, or dinaphthylamino.

Preferred examples of the polycyclic aromatic compounds of the general formula (4) or formula (5) are the following formulae (4-d), (4-e), (4-f), and formula (4-h) and a more preferred example is the following formula (4-f).

[C41]

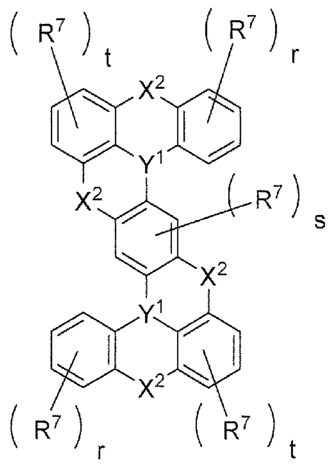

(4-d)

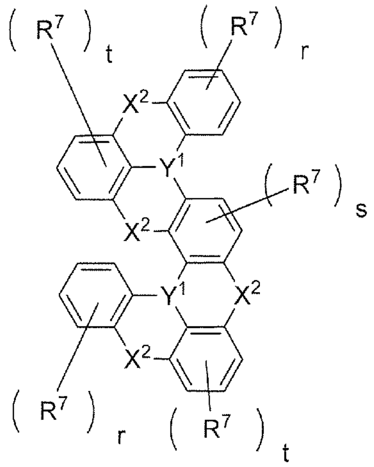

(4-e)

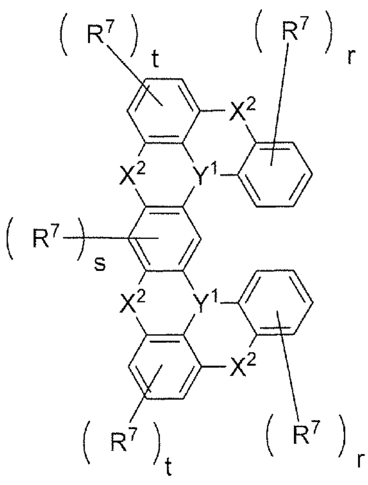

(4-f)

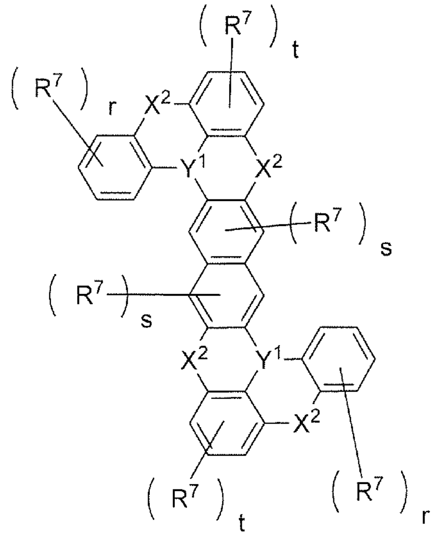

(4-h)

The polycyclic aromatic compounds represented by formula (4-d), formula (4-e), and formula (4-f) correspond to, for example, compounds represented by formula (4-67), formula (4-68), and formula (4-69), which will be described below.

The polycyclic aromatic compounds represented by formula (4-h) correspond to, for example, compounds represented by formula (4-71), formula (4-72), formula (4-73), formula (4-74), and formula (4-75), which will be described below.

In the formulae (4-d) to (4-h), $X^2$ and $Y^1$ have the same meaning as those in formula (4), and $R^7$ has the same

meaning as $R^4$ in formula (5). r each independently represents an integer of 0 to 4, s each independently represents an integer of 0 to 2, and t each independently represents an integer of 0 to 3.

Specific examples of the polycyclic aromatic compounds represented by the general formula (4) or formula (5) will be described below, but are not limited to these exemplified compounds.

[C42]

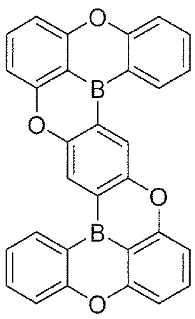
4-67

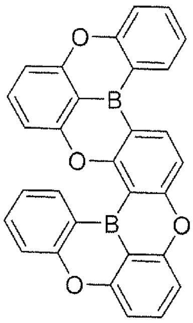
4-68

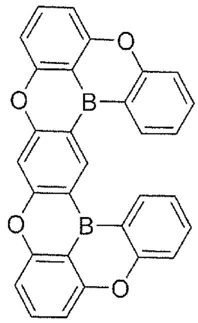
4-69

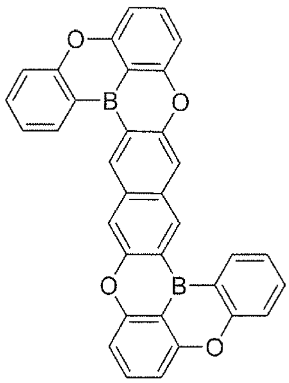
4-71

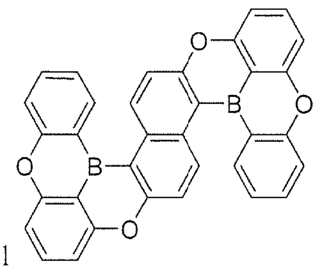
4-72

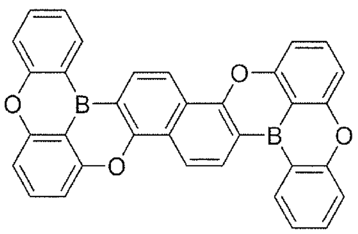
4-73

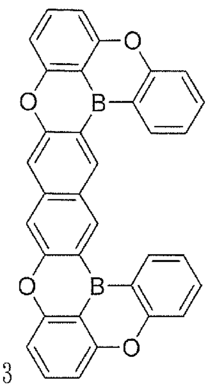
4-74

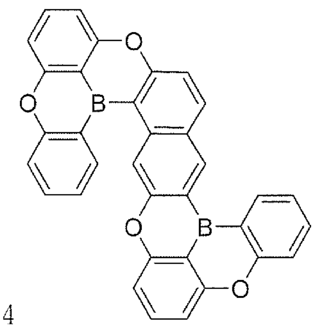
4-75

[C43]

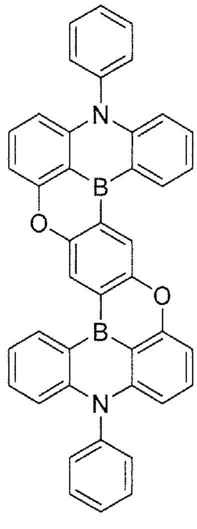

4-78

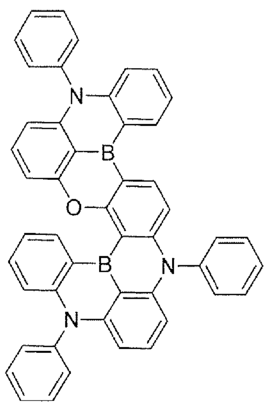

4-79

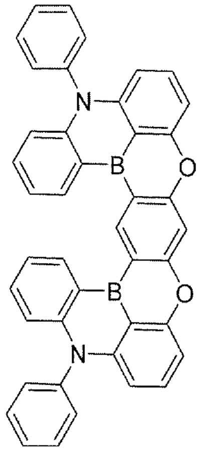

4-80

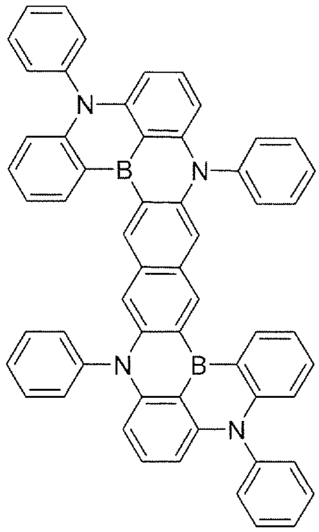

4-82

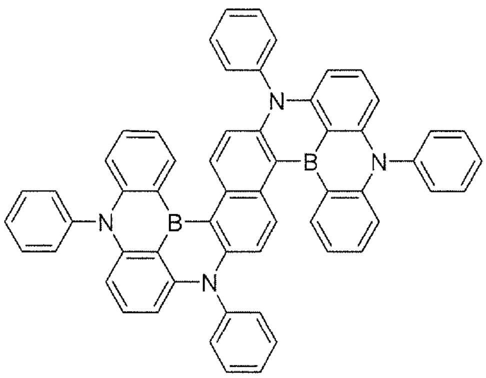

4-83

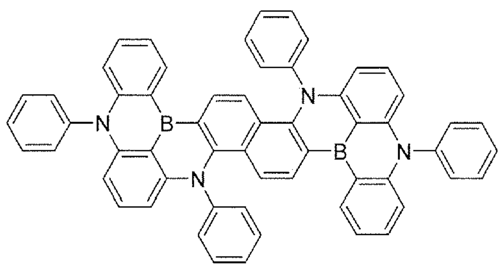

4-84

[C44]

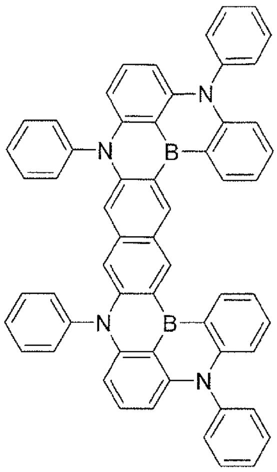
4-85

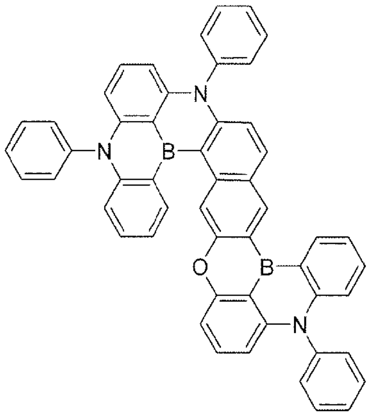
4-86

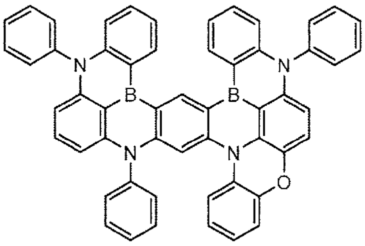
4-87

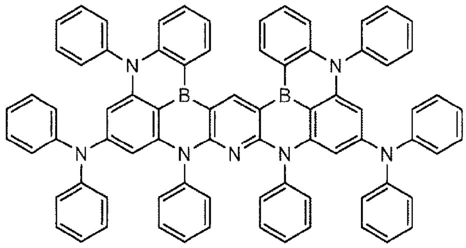
4-88

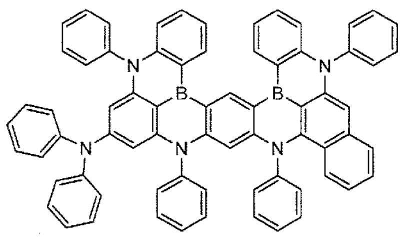
4-89

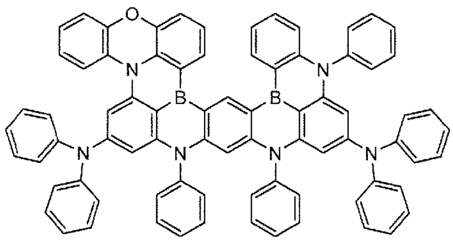
4-90

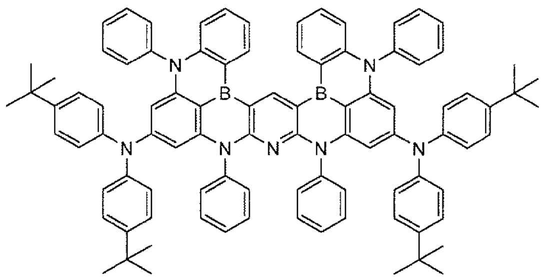
4-91

[C45]

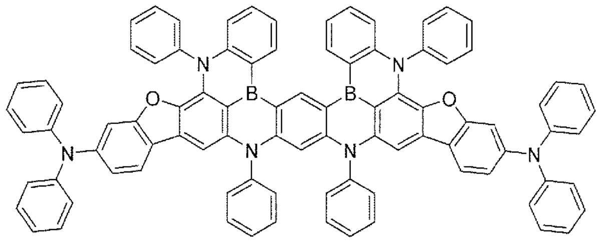

4-92

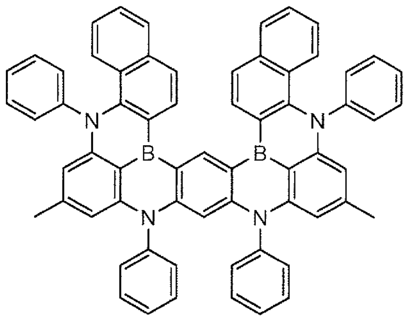

4-93

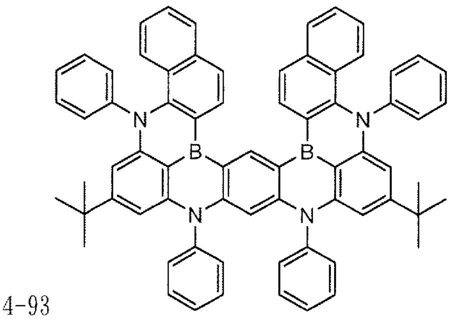

4-94

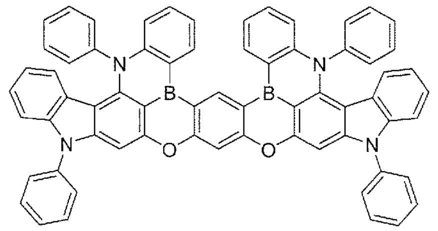

4-95

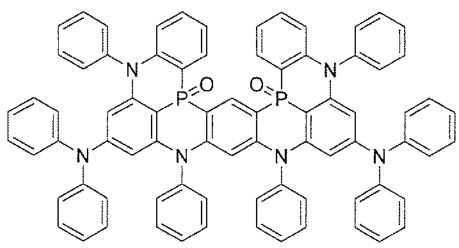

4-96

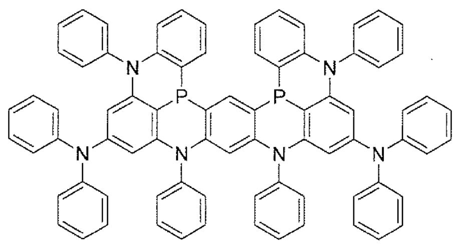

4-97

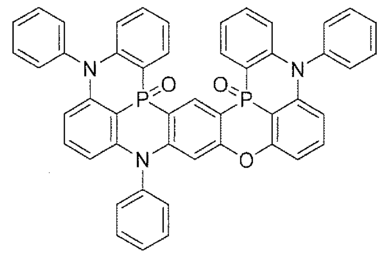

4-98

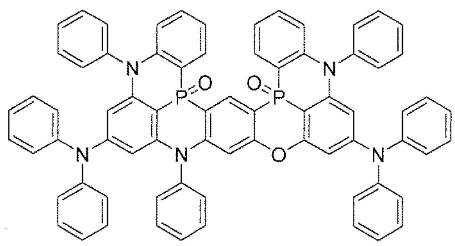

4-99

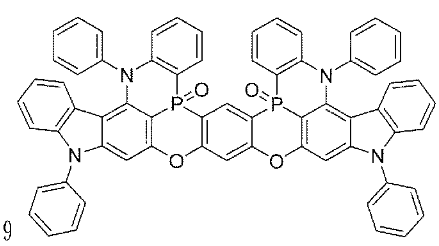

4-100

[C46]

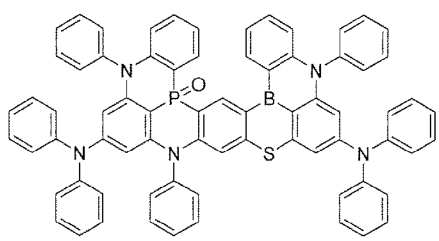

4-101

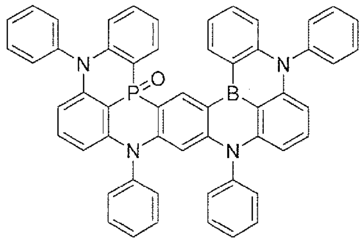

4-102

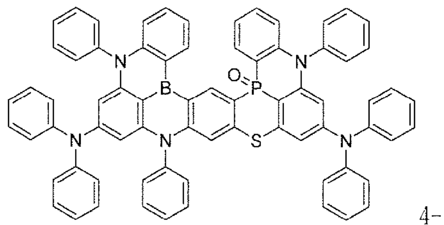

4-103

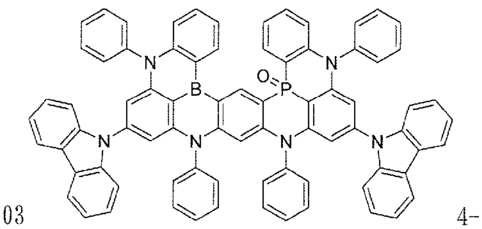

4-104

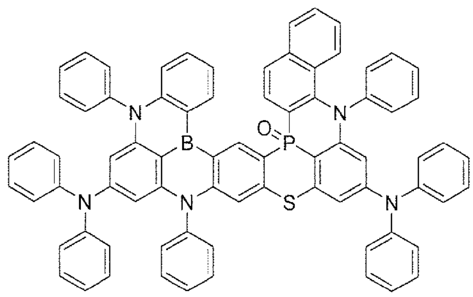

4-105

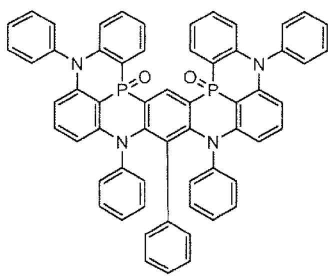

4-106

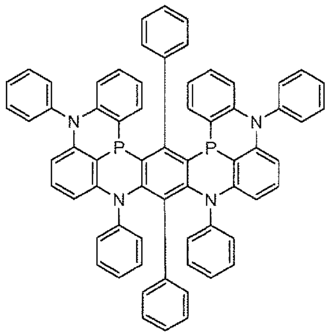

4-107

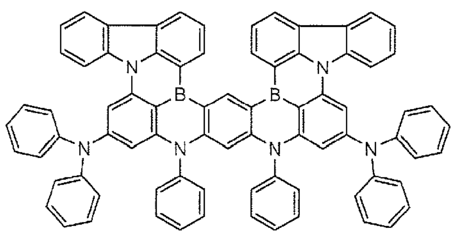

4-108

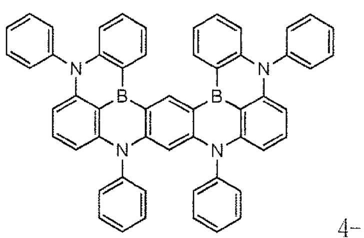

4-109

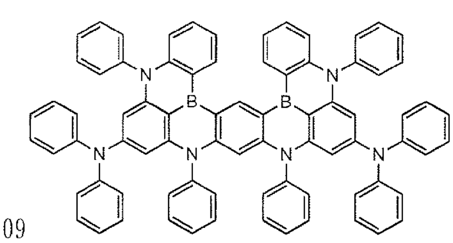

4-110

[C47]

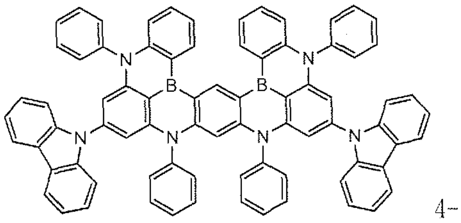

4-111

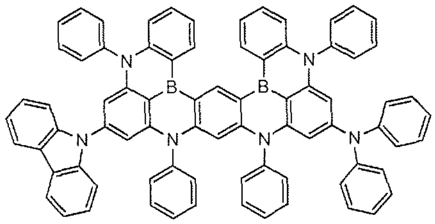

4-112

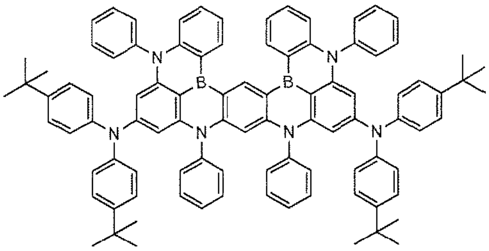

4-113

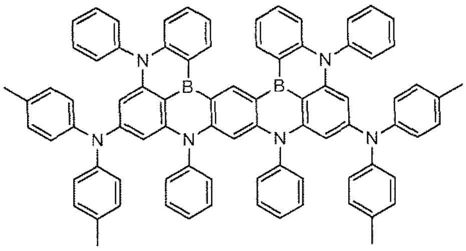

4-114

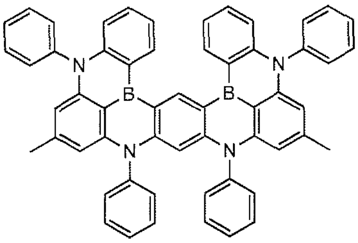

4-115

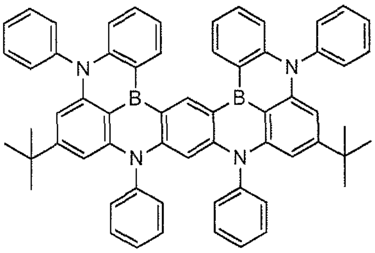

4-116

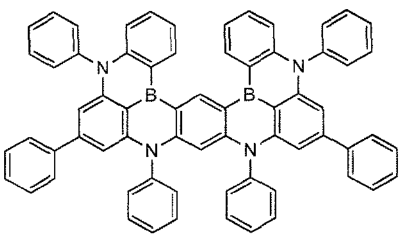

4-117

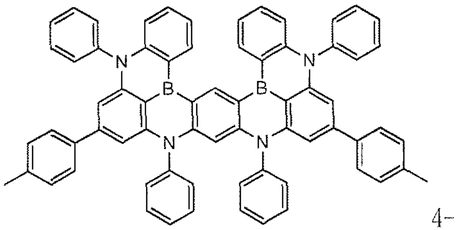

4-118

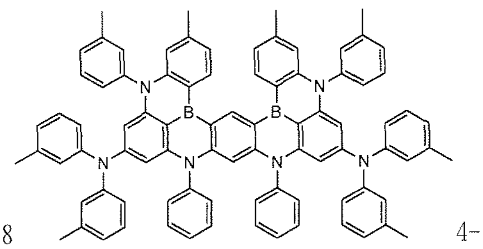

4-119

[C48]

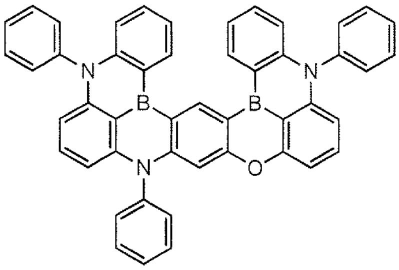

4-120

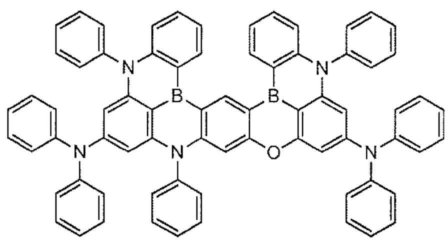

4-121

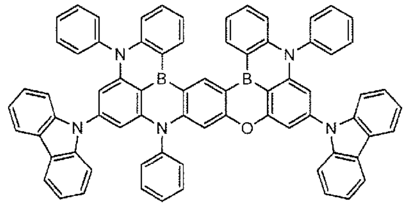

4-122

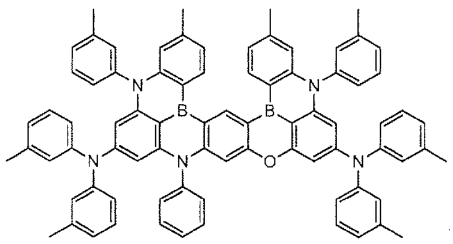

4-123

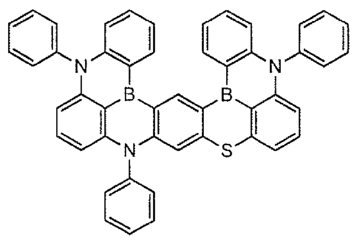

4-124

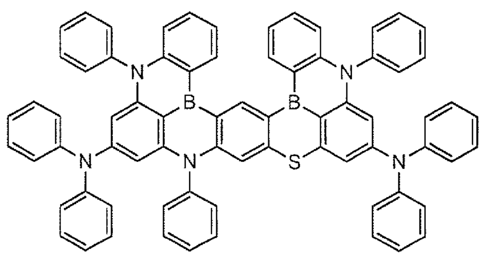

4-125

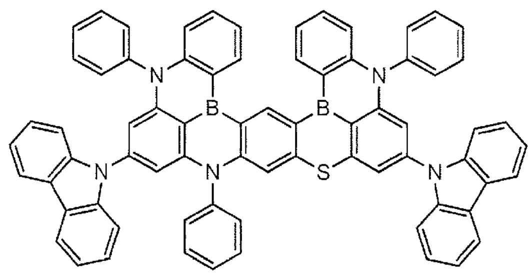

4-126

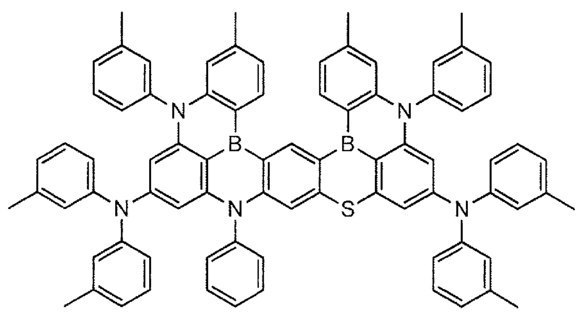

4-127

[C49]

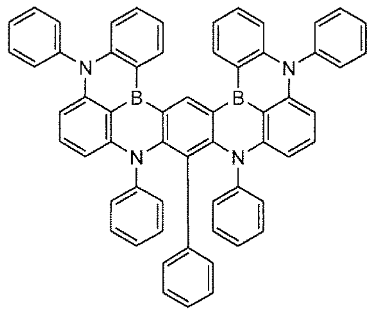

4-128

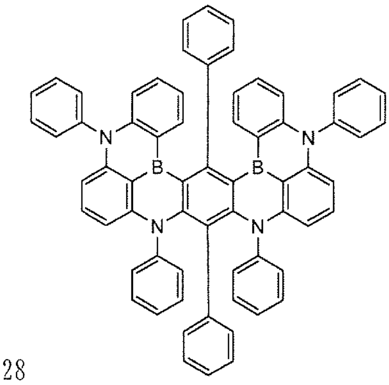

4-129

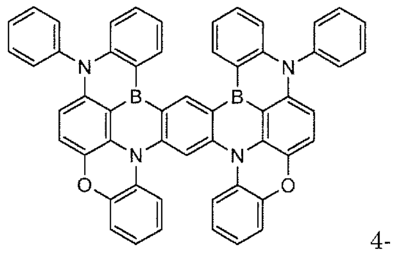

4-130

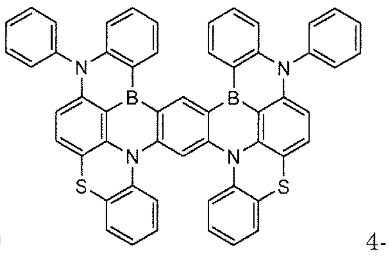

4-131

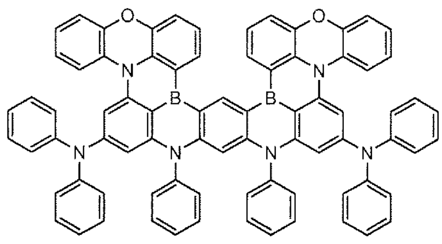

4-132

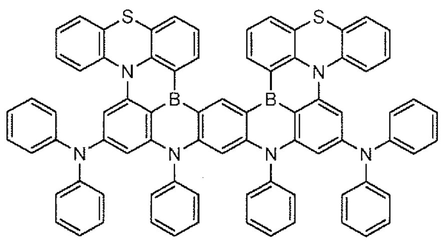

4-133

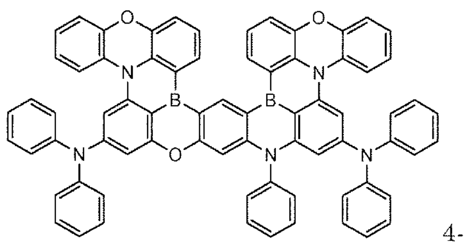

4-134

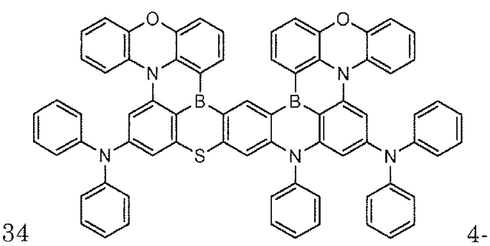

4-135

The organic light emitting material used as a light emitting dopant in the organic EL device of the present invention preferably has a ΔEST of 0.20 eV or less, more preferably 0.15 eV or less, and still more preferably 0.10 eV or less.

The ΔEST represents a difference between excited singlet energy (S1) and excited triplet energy (T1). Here, S1 and T1 are measured under the measurement conditions according to the method described in the Examples.

By using a material selected from the polycyclic aromatic compound represented by the aforementioned general formula (4) (hereinafter referred to as a polycyclic aromatic compound material) as the light emitting dopant, and using a material selected from the compounds represented by the general formula (1) above as the first host and a material selected from the compounds represented by the general formula (2) above as the second host, an excellent organic EL device can be provided.

Next, the structure of the organic EL device of the present invention will be described with reference to the drawings; however, the structure of the organic EL device of the present invention is not limited thereto.

Figure 1 shows a cross-sectional view of a structure example of a typical organic EL device used in the present invention. Reference numeral 1 denotes a substrate, reference numeral 2 denotes an anode, reference numeral 3 denotes a hole injection layer, reference numeral 4 denotes a hole transport layer, reference numeral 5 denotes a light emitting layer, reference numeral 6 denotes an electron transport layer, and reference numeral 7 denotes a cathode. The organic EL device of the present invention may have an exciton blocking layer adjacent to the light emitting layer,

or may have an electron blocking layer between the light emitting layer and the hole injection layer. The exciton blocking layer may be inserted on either the anode side or the cathode side of the light emitting layer or may be inserted on both sides at the same time. The organic EL device of the present invention has the anode, the light emitting layer, and the cathode as essential layers, but preferably has a hole injection/transport layer and an electron injection/transport layer in addition to the essential layers, and further preferably has a hole blocking layer between the light emitting layer and the electron injection/transport layer. The hole injection/transport layer means either or both of the hole injection layer and the hole transport layer, and the electron injection/transport layer means either or both of the electron injection layer and electron transport layer.

It is also possible to have a structure that is the reverse of the structure shown in Figure 1, that is, the cathode 7, the electron transport layer 6, the light emitting layer 5, the hole transport layer 4, and the anode 2 can be laminated on the substrate 1, in the order presented. Also, in this case, layers can be added or omitted, as necessary.

-Substrate-

The organic EL device of the present invention is preferably supported on a substrate. The substrate is not particularly limited and may be a substrate conventionally used for organic EL devices, and for example, a substrate made of glass, transparent plastic, or quartz can be used.

-Anode-

As the anode material in the organic EL device, a material made of a metal, alloy, or conductive compound having a high work function (4 eV or more), or a mixture thereof is preferably used. Specific examples of such an electrode material include metals such as Au, and conductive transparent materials such as CuI, indium tin oxide (ITO), $SnO_2$, and ZnO. An amorphous material capable of producing a transparent conductive film such as IDIXO ($In_2O_3$-ZnO) may also be used. As the anode, these electrode materials may be formed into a thin film by a method such as vapor deposition or sputtering, and then a pattern of a desired form may be formed by photolithography. Alternatively, when a highly precise pattern is not required (about 100 μm or more), a pattern may be formed through a mask of a desired form at the time of vapor deposition or sputtering of the above electrode materials. Alternatively, when a coatable material such as an organic conductive compound is used, a wet film forming method such as a printing method and a coating method can also be used. When light is extracted from the anode, the transmittance is desirably more than 10%, and the sheet resistance as the anode is preferably several hundred Ω/square or less. The film thickness is selected within a range of usually 10 to 1,000 nm, and preferably 10 to 200 nm, although it depends on the material.

-Cathode-

On the other hand, a material made of a metal (referred to as an electron injection metal), alloy, or conductive compound having a low work function (4 eV or less) or a mixture thereof is used as the cathode material. Specific examples of such an electrode material include sodium, a sodium-potassium alloy, magnesium, lithium, a magnesium/copper mixture, a magnesium/silver mixture, a magnesium/aluminum mixture, a magnesium/indium mixture, an aluminum/aluminum oxide ($Al_2O_3$) mixture, indium, a lithium/aluminum mixture, and a rare earth metal. Among them, in terms of electron injection properties and durability against oxidation and the like, a mixture of an electron injection metal with a second metal that has a higher work function value than the electron injection metal and is stable, for example, a magnesium/silver mixture, a magnesium/aluminum mixture, a magnesium/indium mixture, an aluminum/aluminum oxide ($Al_2O_3$) mixture, a lithium/aluminum mixture, or aluminum is suitable. The cathode can be produced by forming a thin film from these cathode materials by a method such as vapor deposition and sputtering. The sheet resistance as the cathode is preferably several hundred Ω/square or less, and the film thickness is selected within a range of usually 10 nm to 5 μm, and preferably 50 to 200 nm. To transmit the light emitted, either one of the anode and the cathode of the organic EL device is favorably transparent or translucent because light emission brightness is improved.

The above metal is formed to have a film thickness of 1 to 20 nm on the cathode, and then a conductive transparent material mentioned in the description of the anode is formed on the metal, so that a transparent or translucent cathode can be produced. By applying this process, a device in which both anode and cathode have transmittance can be produced.

-Light Emitting Layer-

The light emitting layer is a layer that emits light after holes and electrons respectively injected from the anode and the cathode are recombined to form excitons, and the light emitting layer includes the light emitting dopant and the hosts.

The light emitting dopant and the host can be used so that the amount of the light emitting dopant is, for example, 0.10 to 10% and the amount of the host is 99.9% to 90%. Preferably the amount of the light emitting dopant is 1.0 to 5.0% and the amount of the host is 99 to 95%. More preferably the amount of the light emitting dopant is 1.0 to 3.0% and the amount of the host is 99 to 97%.

In the present description, % denotes % by mass unless otherwise noted.

As the hosts in the light emitting layer, the aforementioned first host and the second host are used. For the first host and the second host, for example, the first host can be used in an amount of 10 to 90% and the second host can be used in an amount of 90 to 10%. Preferably, the amount of the first host is 30 to 70% and the amount of the second host is 70 to 30%. More preferably, the amount of the first host is 50 to 70% and the amount of the second host is 50 to 30%.

Furthermore, one or more known hosts as other hosts may be used in combination with those described above, and the amount thereof used may be 50% or less and preferably 25% or less based on the total amount of the host materials.

The other known host that can be used is a compound having the ability to transport hole, the ability to transport electron, and a high glass transition temperature, and preferably has a higher T1 than the T1 of the light emitting dopant. Specifically, the host has a higher T1 than the T1 of the light emitting dopant preferably by 0.010 eV or more, more preferably by 0.030 eV or more, and still more preferably by 0.10 eV or more. A TADF-active compound may also be used as the host material, which preferably has a ΔEST of 0.20 eV or less.

The other known hosts are known in a large number of patent literatures and the like, and hence may be selected from them. Specific examples of the host include, but are not particularly limited to, various metal complexes typified by metal complexes of indole derivatives, carbazole derivatives, indolocarbazole derivatives, triazole derivatives, oxazole derivatives, oxadiazole derivatives, imidazole derivatives, phenylenediamine derivatives, arylamine derivatives, styrylanthracene derivatives, fluorenone derivatives, stilbene derivatives, triphenylene derivatives, carborane derivatives, porphyrin derivatives, phthalocyanine derivatives, and 8-quinolinol derivatives, and metal phthalocyanine, and metal complexes of benzoxazole and benzothiazole derivatives; and polymer compounds such as poly(N-vinyl carbazole)derivatives, aniline-based copolymers, thiophene oligomers, polythiophene derivatives, polyphenylene derivatives, polyphenylene vinylene derivatives, and polyfluorene derivatives.

When a plurality of hosts is used, each host is deposited from different deposition sources, or a plurality of hosts is premixed before vapor deposition to form a premix, whereby a plurality of hosts can be simultaneously deposited from one deposition source.

As the method of premixing, a method by which hosts can be mixed as uniformly as possible is desirable, and examples thereof include, but are not limited to, milling, a method of heating and melting hosts under reduced pressure or under an inert gas atmosphere such as nitrogen, and sublimation.

The premix may be in a form of powder, a stick, or granules.

The aforementioned polycyclic aromatic compound materials can be used as the light emitting dopant in the light emitting layer.

The light emitting layer can include two or more light emitting dopants. For example, the aforementioned polycyclic aromatic compound material and another compound as another light emitting dopant may be included. In this case, the other compound as another light emitting dopant preferably has a ΔEST of 0.20 eV or less, but not limited to such a compound.

When two or more light emitting dopants are included in the light emitting layer, the first dopant is a compound represented by the general formulae (4) or formula (5), and the second dopant to be combined may be a known compound as the light emitting dopant. The content of the first dopant is preferably 0.050 to 50% relative to the host materials, and the content of the second dopant is preferably 0.050 to 50% relative to the host materials. The total content of the first dopant and the second dopant do not exceed 50% relative to the host materials.

Such other light emitting dopants are known in a large number of patent literatures and the like, and may be selected therefrom. Specific examples of the dopants include, but not limited to, fused ring derivatives such as phenanthrene, anthracene, pyrene, tetracene, pentacene, perylene, naphthopyren, dibenzopyren, rubrene, and chrysene, benzoxazole derivatives, benzothiazole derivatives, benzoimidazole derivatives, benzotriazole derivatives, oxazole derivatives, oxadiazole derivatives, thiazole derivatives, imidazole derivatives, thiadiazole derivatives, triazole derivatives, pyrazoline derivatives, stilbene derivatives, thiophene derivatives, tetraphenylbutadiene derivatives, cyclopentadiene derivatives, bisstyryl derivatives such as bisstyrylanthracene derivatives and distyrylbenzene derivatives, bisstyrylarylene derivatives, diazaindacene derivatives, furan derivatives, benzofuran derivatives, isobenzofuran derivatives, dibenzofuran derivatives, coumarin derivatives, dicyanomethylenopyran derivatives, dicyanomethylenethiopyran derivatives, polymethine derivatives, cyanine derivatives, oxobenzoanthracene derivatives, xanthene derivatives, rhodamine derivatives, fluorescein derivatives, pyrylium derivatives, carbostyryl derivatives, acridine derivatives, oxazine derivatives, phenylene oxide derivatives, quinacridone derivatives, quinazoline derivatives, pyrrolopyridine derivatives, fluoropyridine derivatives, 1,2,5-thiadiazolopyrene derivatives, pyrromethene derivatives, perinone derivatives, pyrrolopyrrole derivatives, squarylium derivatives, violanthrone derivatives, phenazine derivatives, acridone derivatives, deazaflavin derivatives, fluorene derivatives, benzofluorene derivatives, etc.

The light emitting dopant and the first or second host can be vapor deposited from different vapor deposition sources, or the light emitting dopant and the first or second host can be premixed before vapor deposition to form a premix, whereby they can be simultaneously deposited from one deposition source.

-Injection Layer-

The injection layer refers to a layer provided between the electrode and the organic layer to reduce the driving voltage and improve the light emission brightness, and includes the hole injection layer and the electron injection layer. The injection layer may be present between the anode and the light emitting layer or the hole transport layer, as well as between the cathode and the light emitting layer or the electron transport layer. The injection layer may be provided as necessary.

-Hole Blocking Layer-

The hole blocking layer has the function of the electron transport layer in a broad sense, is made of a hole blocking material having a very small ability to transport holes while having the function of transporting electrons, and can improve the recombination probability between the electrons and the holes in the light emitting layer by blocking the holes while transporting the electrons. For the hole blocking layer, a known hole blocking material can be used. To exhibit the characteristics of the light emitting dopant, the material used as the second host can also be used as the material for the hole blocking layer. A plurality of hole blocking materials may be used in combination.

-Electron Blocking Layer-

The electron blocking layer has the function of the hole transport layer in a broad sense, and can improve the recombination probability between the electrons and the holes in the light emitting layer by blocking the electrons while transporting the holes. As the material for the electron blocking layer, a known material for the electron blocking layer can be used. To exhibit the characteristics of the light emitting dopant, the material used as the first host can also be used as the material for the electron blocking layer. The film thickness of the electron blocking layer is preferably 3 to 100 nm, and more preferably 5 to 30 nm.

-Exciton Blocking Layer-

The exciton blocking layer is a layer to block the diffusion of the excitons generated by recombination of the holes and the electrons in the light emitting layer into a charge transport layer, and insertion of this layer makes it possible to efficiently keep the excitons in the light emitting layer, so that the emission efficiency of the device can be improved. The exciton blocking layer can be inserted between two light emitting layers adjacent to each other in the device in which two or more light emitting layers are adjacent to each other.

As the material for the exciton blocking layer, a known material for the exciton blocking layer can be used.

The layer adjacent to the light emitting layer includes the hole blocking layer, the electron blocking layer, and the exciton blocking layer, and when these layers are not provided, the adjacent layer is the hole transport layer, the electron transport layer, and the like.

-Hole Transport Layer-

The hole transport layer is made of a hole transport material having the function of transporting holes, and the hole transport layer may be provided as a single layer or a plurality of layers.

The hole transport material has any of hole injection properties, hole transport properties, or electron barrier properties, and may be either an organic material or an inorganic material. As the hole transport layer, any of conventionally known compounds may be selected and used. Examples of such a hole transport material include porphyrin derivatives, arylamine derivatives, triazole derivatives, oxadiazole derivatives, imidazole derivatives, polyarylalkane derivatives, phenylenediamine derivatives, arylamine derivatives, amino-substituted chalcone derivatives, oxazole derivatives, styrylanthracene derivatives, fluorenone derivatives, hydrazone derivatives, stilbene derivatives, silazane derivatives, aniline-based copolymers, and conductive polymer oligomers, particularly, thiophene oligomers. Porphyrin derivatives, arylamine derivatives, and styrylamine derivatives are preferably used, and arylamine compounds are more preferably used.

-Electron Transport Layer-

The electron transport layer is made of a material having the function of transporting electrons, and the electron transport layer may be provided as a single layer or a plurality of layers.

The electron transport material (may also serve as the hole blocking material) has the function of transmitting electrons injected from the cathode to the light emitting layer. As the electron transport layer, any of conventionally known compounds may be selected and used, and examples thereof include polycyclic aromatic derivatives such as naphthalene, anthracene, and phenanthroline, tris(8-quinolinolato)aluminum (III) derivatives, phosphine oxide derivatives, nitro-substituted fluorene derivatives, diphenylquinone derivatives, thiopyran dioxide derivatives, carbodiimides, fluorenylidene methane derivatives, anthraquinodimethane and anthrone derivatives, bipyridine derivatives, quinoline derivatives, oxadiazole derivatives, benzimidazole derivatives, benzothiazole derivatives, and indolocarbazole derivatives. Further, polymer materials in which these materials are introduced in the polymer chain or these materials constitute the main chain of the polymer can also be used.

When the organic EL device of the present invention is produced, the film formation method of each layer is not particularly limited, and the layers may be produced by either a dry process or a wet process.

Examples

Hereinafter, the present invention will be described in further detail with reference to Examples, but the present invention is not limited to these Examples.

The compounds used in Examples and Comparative Examples are shown below.

[C50]

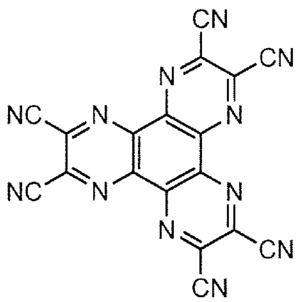
HAT-CN

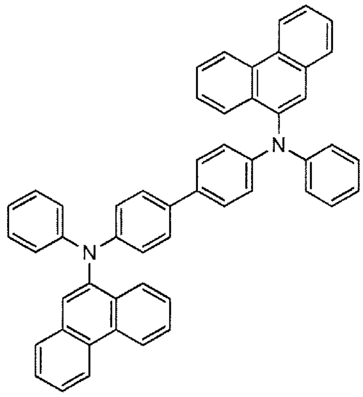
HT-1

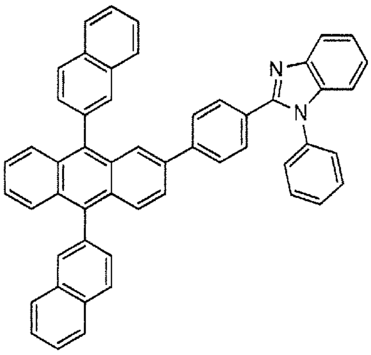
ET-1

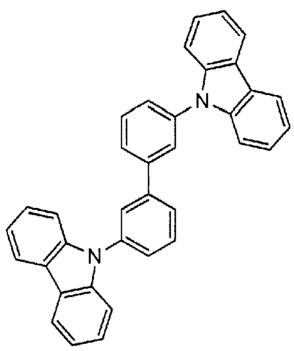
mCBP

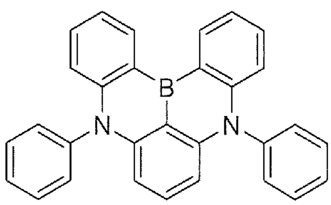
BD1

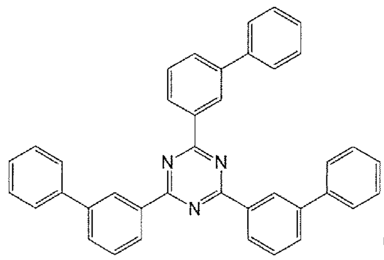
T2T

S1 and T1 of the compound BD1, (4-110) and (4-121) were measured. S1 and T1 were measured as follows: The compound (1-58) as the host, and compound BDI, the compound (4-110) or (4-121) as the light emitting dopant were co-deposited from different vapor deposition sources on a quartz substrate by a vacuum evaporation method at a degree of vacuum of $10^{-4}$ Pa or less, to form a deposition film with a thickness of 100 nm. At this time, they were co-deposited under deposition conditions such that the concentration of the light emitting dopant was 3%.

For S1, the emission spectrum of this deposition film was measured, a tangent was drawn to the rise of the emission spectrum on the short-wavelength side, and the wavelength value λedge [nm] of the point of intersection of the tangent and the horizontal axis was substituted into the following equation (i) to calculate S1.

$$S1\ [eV] = 1239.85/\lambda edge \qquad (i)$$

For T1, the phosphorescence spectrum of the above deposition film was measured, a tangent was drawn to the rise of the phosphorescence spectrum on the short-wavelength side, and the wavelength value kedge [nm] of the point of intersection of the tangent and the horizontal axis was substituted into the following equation (ii) to calculate T1.

$$T1\ [eV] = 1239.85/\lambda edge \qquad (ii)$$

The measurement results are shown in Table 1.

[Table 1]

| Compound | S1 (eV) | T1 (eV) | S1-T1 (eV) |
|---|---|---|---|
| BD1 | 2.79 | 2.61 | 0.18 |
| 4-110 | 2.71 | 2.67 | 0.04 |
| 4-121 | 2.76 | 2.71 | 0.05 |

Example 1

Each thin film was laminated on the glass substrate on which an anode made of ITO having a film thickness of 70 nm was formed by a vacuum deposition method at a degree of vacuum of $4.0 \times 10^{-5}$ Pa. First, HAT-CN was formed on ITO to a thickness of 10 nm as a hole injection layer, and then HT-1 was formed to a thickness of 25 nm as a hole transport layer. Then, the compound (1-58) was formed to a thickness of 5 nm as an electron blocking layer. Then, the compound (1-58) as the first host, a compound (2-6) as the second host, and the compound (4-121) as the light emitting dopant were vapor co-deposited from different vapor deposition sources to form a light emitting layer to a thickness of 30 nm. At this time, they were vapor co-deposited under the vapor deposition conditions such that the concentration of the compound (4-121) was 2% and the mass ratio of the first host to the second host was 70:30. Then, compound (2-6) was formed to a thickness of 5 nm as a hole blocking layer. Then, ET-1 was formed to a thickness of 40 nm as an electron transport layer. Lithium fluoride (LiF) was formed on the electron transport layer to a thickness of 1 nm as an electron injection layer. Finally, aluminum (Al) was formed on the electron injection layer to a thickness of 70 nm as a cathode, whereby an organic EL device was produced.

Examples 2 to 9

Each organic EL device was produced in the same manner as in Example 1, except that the light emitting dopant, the first host, and the second host, as well as the mass ratio of the first host and the second host were changed as shown in Table 2.

Comparative Example 1

Each thin film was laminated on the glass substrate on which an anode made of ITO having a film thickness of 70 nm was formed by a vacuum deposition method at a degree of vacuum of $4.0 \times 10^{-5}$ Pa. First, HAT-CN was formed on ITO to a thickness of 10 nm as a hole injection layer, and then HT-1 was formed to a thickness of 25 nm as a hole transport layer. Then, the compound (1-58) was formed to a thickness of 5 nm as an electron blocking layer. Then, the compound (1-58) as the first host and the compound (4-121) as the light emitting dopant were co-deposited from different

vapor deposition sources to form a light emitting layer having a thickness of 30 nm. At this time, they were co-deposited under vapor deposition conditions such that the concentration of the compound (4-121) was 2%. Then, ET-1 was formed to a thickness of 40 nm as an electron transport layer. Further, lithium fluoride (LiF) was formed on the electron transport layer to a thickness of 1 nm as an electron injection layer. Finally, aluminum (Al) was formed on the electron injection layer to a thickness of 70 nm as a cathode, whereby an organic EL device was produced.

Comparative Examples 3, 5, and 7

Each organic EL device was produced in the same manner as in Comparative Example 1, except that the light emitting dopant and the first host (no second host) were changed to the compounds shown in Table 2.

Comparative Examples 2 and 6

Each organic EL device was produced in the same manner as in Comparative Example 1, except that the light emitting dopant and the second host (no first host) were changed to the compounds shown in Table 2.

Comparative Examples 4, 8, 9, and 10

Each organic EL device was produced in the same manner as in Example 1, except that the light emitting dopant, the first host, and the second host were changed to the compounds and the mass ratio shown in Table 2.

[Table 2]

| | Dopant | First host | Second host |
|---|---|---|---|
| Example 1 | 4-121 | 1-58 (70%) | 2-6 (30%) |
| Example 2 | 4-121 | 1-58 (50%) | 2-6 (50%) |
| Example 3 | 4-121 | 1-58 (30%) | 2-6 (70%) |
| Example 4 | 4-121 | 1-58 (70%) | 2-84 (30%) |
| Example 5 | 4-121 | 1-81 (50%) | 2-84 (50%) |
| Example 6 | 4-110 | 1-58 (50%) | 2-6 (50%) |
| Example 7 | 4-110 | 1-58 (50%) | 2-1 (50%) |
| Example 8 | 4-110 | 1-31 (50%) | 2-84 (50%) |
| Example 9 | 4-110 | 1-81 (50%) | 2-11 (50%) |
| Comparative Example 1 | 4-121 | 1-58 | - |
| Comparative Example 2 | 4-121 | - | 2-6 |
| Comparative Example 3 | 4-121 | mCBP | - |
| Comparative Example 4 | 4-121 | mCBP (50%) | 2-6 (50%) |
| Comparative Example 5 | 4-110 | 1-58 | - |
| Comparative Example 6 | 4-110 | - | 2-1 |
| Comparative Example 7 | 4-110 | mCBP | - |
| Comparative Example 8 | BD1 | 1-58 (50%) | 2-6 (50%) |
| Comparative Example 9 | BD1 | 1-58 (50%) | 2-84 (50%) |
| Comparative Example 10 | 4-110 | mCBP (50%) | T2T (50%) |

Table 3 shows the maximum emission wavelength of the light emission spectrum, the external quantum efficiency, and the lifetime of each organic EL device produced in the Examples and Comparative Examples. The maximum emission wavelength and the external quantum efficiency were values at a luminance of 500 cd/$m^2$ and were initial properties. The time taken for the luminance to reduce to 50% of the initial luminance when the initial luminance was 500 cd/$m^2$ was measured as the lifetime.

[Table 3]

| | Maximum emission wavelength (nm) | External quantum efficiency (%) | Lifetime (h) |
|---|---|---|---|
| Example 1 | 465 | 12.0 | 195 |
| Example 2 | 465 | 13.5 | 189 |
| Example 3 | 465 | 12.8 | 163 |
| Example 4 | 466 | 15.0 | 252 |
| Example 5 | 466 | 14.7 | 183 |
| Example 6 | 470 | 19.2 | 205 |
| Example 7 | 470 | 18.9 | 187 |
| Example 8 | 472 | 18.5 | 231 |
| Example 9 | 472 | 18.1 | 180 |
| Comparative Example 1 | 464 | 8.2 | 51 |
| Comparative Example 2 | 466 | 7.8 | 76 |
| Comparative Example 3 | 465 | 11.8 | 84 |
| Comparative Example 4 | 466 | 12.1 | 98 |
| Comparative Example 5 | 470 | 17.7 | 83 |
| Comparative Example 6 | 471 | 17.0 | 78 |
| Comparative Example 7 | 470 | 17.4 | 88 |
| Comparative Example 8 | 461 | 11.3 | 63 |
| Comparative Example 9 | 461 | 10.9 | 53 |
| Comparative Example 10 | 471 | 14.2 | 79 |

It is found from Table 3 that the organic EL devices in the Examples are characterized by the high efficiency and the long lifetime, and exhibit blue luminescence in view of the maximum emission wavelength.

Industrial Applicability

The organic EL device of the present invention has high emission efficiency and the long lifetime.

Reference Signs List

1 substrate, 2 the anode, 3 hole injection layer, 4 hole transport layer, 5 light emitting layer, 6 electron transport layer, 7 cathode

## Claims

1. An organic electroluminescent device comprising one or more light emitting layers between an anode and a cathode opposite to each other, wherein at least one of the light emitting layers comprises a first host selected from compounds represented by the following general formula (1), a second host selected from compounds represented by the following general formula (2), and a light emitting dopant selected from a polycyclic aromatic compound represented by the following general formula (4) :

[C1]

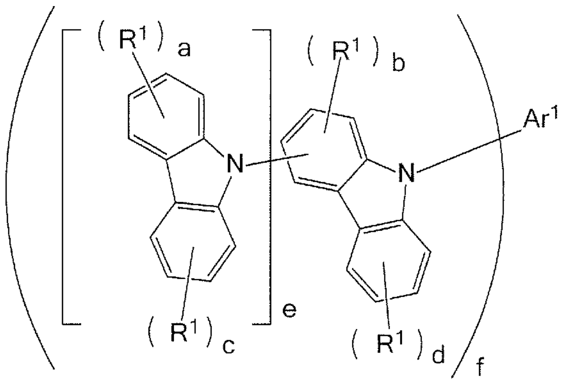

(1)

wherein $Ar^1$ represents a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group formed by linking 2 to 8 aromatic rings thereof,

$R^1$ is each independently deuterium, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms,

a, c and d independently represent an integer of 0 to 4, b independently represents an integer of 0 to 3, e independently represents an integer of 1 to 4, and f represents an integer of 1 or 2,

when f is 2, the general formula (1) is symmetric or asymmetric,

[C2]

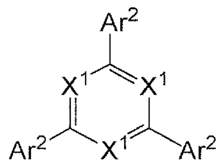

(2)

wherein $X^1$ each independently represents N or C-$R^2$, and at least one $X^1$ represents N,

$Ar^2$ each independently represents hydrogen, a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group formed by linking 2 to 8 aromatic rings thereof, and at least one $Ar^2$ is a group other than hydrogen,

$R^2$ independently represents hydrogen, deuterium, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms,

[C3]

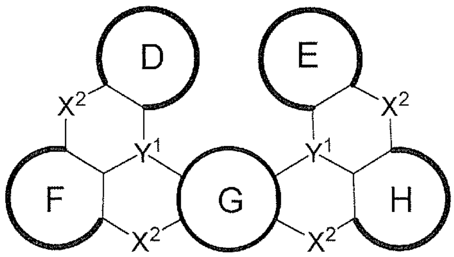

(4)

wherein the D ring, the E ring, the F ring, the G ring and the H ring are each independently a substituted or unsubstituted aromatic hydrocarbon ring having 6 to 24 carbon atoms or a substituted or unsubstituted aromatic

heterocyclic ring having 3 to 17 carbon atoms,
$Y^1$ is B, P, P=O, P=S, Al, Ga, As, Si-$R^3$ or Ge-$R^3$,
$R^3$ is each independently an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms,
$X^2$ is each independently O, N-$Ar^3$, S or Se,
$Ar^3$ is each independently a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group formed by linking 2 to 8 thereof, and N-$Ar^3$ is optionally bonded to any of the D ring, the E ring, the F ring, the G ring, or the H ring to form a heterocyclic ring containing N.

**2.** The organic electroluminescent device according to claim 1, wherein $Ar^1$ in the general formula (1) is a substituted or unsubstituted aromatic hydrocarbon group having 6 to 18 carbon atoms or a substituted or unsubstituted condensed aromatic heterocyclic group having 6 to 17 carbon atoms.

**3.** The organic electroluminescent device according to claim 1 or 2, wherein the polycyclic aromatic compound represented by the general formula (4) is a boron-containing polycyclic aromatic compound represented by the following general formula (5):

[C4]

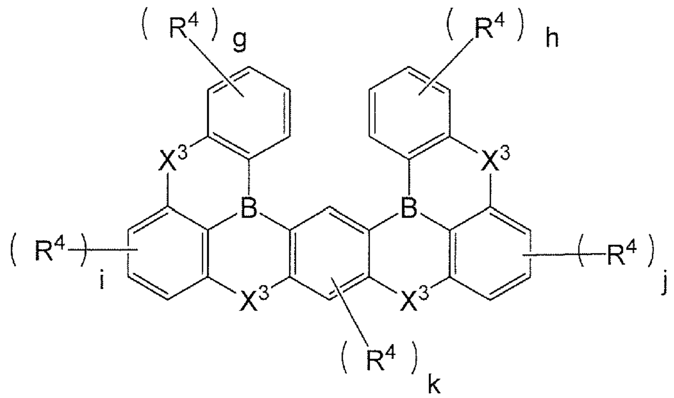

(5)

wherein $X^3$ each independently represents N-$Ar^4$, O, or S, and at least one $X^3$ represents N-$Ar^4$,
$Ar^4$ each independently represents a substituted or unsubstituted aromatic hydrocarbon group having 6 to 18 carbon atoms, a substituted or unsubstituted aromatic heterocyclic ring group having 3 to 17 carbon atoms, or a substituted or unsubstituted linked aromatic group formed by linking 2 to 8 aromatic rings thereof, and N-$Ar^4$ is optionally bonded to a benzene ring to which N-$Ar^4$ is bonded to form a heterocyclic ring containing N,
$R^4$ each independently represents a cyano group, deuterium, a diarylamino group having 12 to 44 carbon atoms, an aliphatic hydrocarbon group having 1 to 10 carbon atoms, a substituted or unsubstituted aromatic hydrocarbon group having 6 to 18 carbon atoms, or a substituted or
unsubstituted aromatic heterocyclic group having 3 to 17 carbon atoms,
g and h each independently represent an integer of 0 to 4, i and j each independently represent an integer of 0 to 3, and k represents an integer of 0 to 2.

**4.** The organic electroluminescent device according to any one of claims 1 to 3, wherein the general formula (2) is the following formula (6):

[C5]

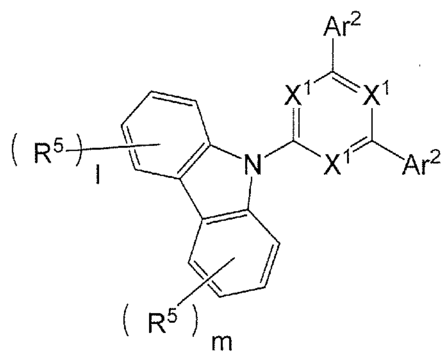

(6)

wherein $Ar^2$ and $X^1$ are as defined in the general formula (2),
$R^5$ each independently represents deuterium, an aliphatic hydrocarbon group having 1 to 10 carbon atoms, a triaryl silyl group having 18 to 36 carbon atoms, or a substituted or unsubstituted aromatic hydrocarbon group having 6 to 18 carbon atoms, or a substituted or unsubstituted aromatic heterocyclic group having 3 to 17 carbon atoms,
l and m each independently represent an integer of 0 to 4.

**5.** The organic electroluminescent device according to any one of claims 1 to 4, wherein the general formula (2) is the following formula (7):

[C6]

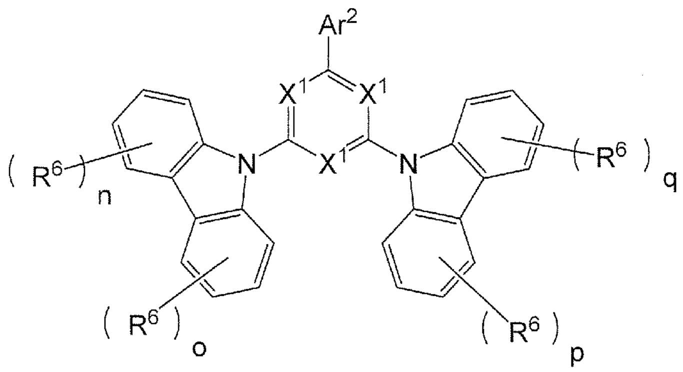

(7)

wherein $Ar^2$ and $X^1$ are as defined in the general formula (2),
$R^6$ each independently represents deuterium, an aliphatic hydrocarbon group having 1 to 10 carbon atoms, a triaryl silyl group having 18 to 36 carbon atoms, or a substituted or unsubstituted aromatic hydrocarbon group having 6 to 18 carbon atoms, or a substituted or unsubstituted aromatic heterocyclic group having 3 to 17 carbon atoms,
n, o, p, and q each independently represent an integer of 0 to 4.

**6.** The organic electroluminescent device according to any one of claims 1 to 5, wherein the general formula (2) is the following formula (8):

[C7]

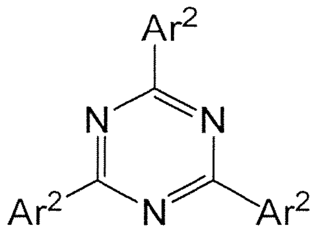

(8)

wherein $Ar^2$ is as defined in the general formula (2).

7. The organic electroluminescent device according to any one of claims 1 to 6, wherein the light emitting dopant has a difference (Δ EST) between excited singlet energy (S1) and excited triplet energy (T1) of 0.20 eV or less.

8. The organic electroluminescent device according to claim 7, wherein the Δ EST is 0.10 eV or less.

[Fig. 1]

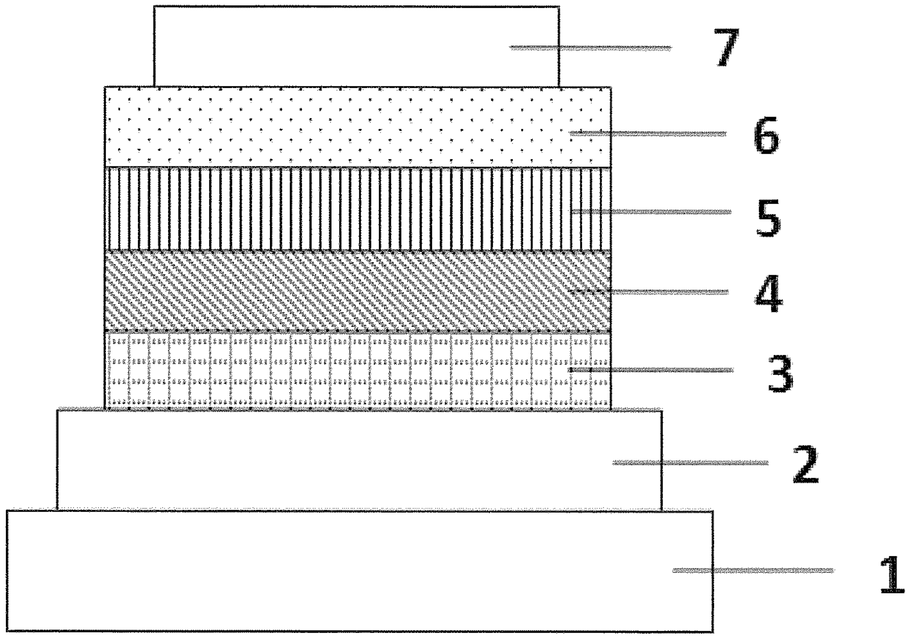

## INTERNATIONAL SEARCH REPORT

International application No.
**PCT/JP2021/031430**

**A. CLASSIFICATION OF SUBJECT MATTER**

***C09K 11/06***(2006.01)i; ***H01L 51/50***(2006.01)i
FI: H05B33/14 B; C09K11/06 660; C09K11/06 690

According to International Patent Classification (IPC) or to both national classification and IPC

**B. FIELDS SEARCHED**

Minimum documentation searched (classification system followed by classification symbols)

C09K11/06; H01L51/50

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X<br><br><br><br>Y | WO 2020/040298 A1 (KWANSEI GAKUIN EDUCATIONAL FOUNDATION) 27 February 2020 (2020-02-27)<br>claims, paragraphs [0001], [0010], [0038]-[0051], [0125]-[0146], [0344]-[0383] (dopant compound ED1) | 1-3, 7-8<br><br><br><br>1-8 |
| Y | WO 2016/158191 A1 (NIPPON STEEL CHEMICAL & MATERIAL CO., LTD.) 06 October 2016 (2016-10-06)<br>claims, paragraphs [0025], [0054]-[0077], [0089], [0090], table 6 | 1-8 |
| A | US 2020/0203652 A1 (KUNSHAN GO-VISIONOX OPTO-ELECTRONICS CO., LTD.) 25 June 2020 (2020-06-25)<br>entire text, all drawings | 1-8 |
| P, X | WO 2021/131766 A1 (NIPPON STEEL CHEMICAL & MATERIAL CO., LTD.) 01 July 2021 (2021-07-01)<br>claims, examples (in particular, luminescent dopant such as compounds 4-2, first host in general formula (1), second host in general formula (2)) | 1-8 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **08 October 2021** | **26 October 2021** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br><br>Telephone No. |

Form PCT/ISA/210 (second sheet) (January 2015)

**INTERNATIONAL SEARCH REPORT**

International application No.
**PCT/JP2021/031430**

**C. DOCUMENTS CONSIDERED TO BE RELEVANT**

| Category* | Citation of document, with indication, where appropriate, of the relevant passages | Relevant to claim No. |
|---|---|---|
| P, A | US 2021/0098714 A1 (SAMSUNG DISPLAY CO., LTD.) 01 April 2021 (2021-04-01) entire text, all drawings | 1-8 |

Form PCT/ISA/210 (second sheet) (January 2015)

**INTERNATIONAL SEARCH REPORT**
**Information on patent family members**

International application No.
**PCT/JP2021/031430**

| Patent document cited in search report | Publication date (day/month/year) | Patent family member(s) | Publication date (day/month/year) |
|---|---|---|---|
| WO 2020/040298 A1 | 27 February 2020 | (Family: none) | |
| WO 2016/158191 A1 | 06 October 2016 | US 2018/0083201 A1<br>claims, paragraphs [0045], [0077]-[0092], [0111]-[0113], table 6<br>EP 3279961 A1<br>CN 107431140 A<br>KR 10-2017-0137036 A<br>TW 201704209 A | |
| US 2020/0203652 A1 | 25 June 2020 | WO 2020/042626 A1<br>CN 109411634 A | |
| WO 2021/131766 A1 | 01 July 2021 | (Family: none) | |
| US 2021/0098714 A1 | 01 April 2021 | EP 3800683 A1 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2010134350 A
- WO 2011070963 A
- WO 2015102118 A
- WO 2017115833 A
- WO 2018212169 A
- WO 2018181188 A
- WO 2020040298 A
- JP 2020120096 A